# EUROPEAN PATENT SPECIFICATION

(11) **EP 1 975 637 B1**
(45) Date of publication and mention of the grant of the patent: **26.10.2011**
(21) Application number: 08153527.0
(22) Date of filing: 28.03.2008
(51) Int. Cl.: G01R 33/12

(54) **Magnetic substance detection sensor and magnetic substance detecting apparatus**
Sensor zur Detektion magnetischer Substanzen und Vorrichtung zur Detektion magnetischer Substanzen
Capteur de détection de substances magnétiques et appareil de détection de substances magnétiques

(30) Priority: 29.03.2007 JP 2007088032; 29.03.2007 JP 2007088033; 29.03.2007 JP 2007088034
(43) Date of publication of application: 01.10.2008
(73) Proprietor: CANON DENSHI KABUSHIKI KAISHA, Chichibu-shi Saitama 369-1892 (JP)
(72) Inventor: Suzuki, Naruki, Chichibu-shi, Saitama (JP)
(74) Representative: TBK

(56) References cited:
- US-A- 5 512 822
- US-B1- 6 310 475

## Description

### BACKGROUND OF THE INVENTION

### Field of the Invention

The present invention relates to a magnetic substance detection sensor used in detection of a medium including magnetic material, etc., and a magnetic substance detecting apparatus using such a sensor.

### Description of the Prior art

As a sensor used for detecting magnetic ink or magnetic particles, etc. included in a medium, sensors using a magnetic head or magnetoresistance element have been known. Since these sensors are configured to detect gradient of magnetic distribution of a medium, they are effective for a use purpose of detecting presence or absence of magnetism such as pattern recognition, etc.

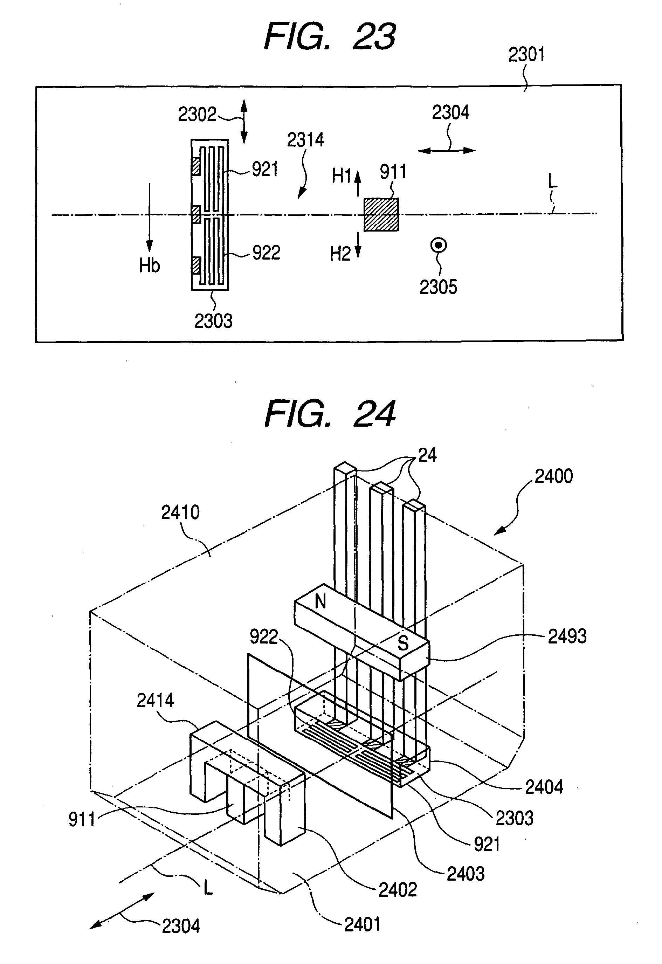

On the contrary, there is proposed a sensor using a high sensitivity magnetic field detection element such as magnetoimpedance element, etc. thus to have ability to detect not only presence or absence of magnetism, but also magnetic distribution of a medium in a quantitative manner (Japanese Patent Application Laid-Open No. 2000-105847). This sensor includes a unit for magnetize a medium before detection as shown in FIGS. 23 and 24, and serves to detect a magnetic field symmetrically produced from the central axis L of the magnetization part of the medium by two magnetoimpedance elements arranged along the magnetic field sense direction. In FIG. 23, the part designated by reference numeral 2301 is a printing medium, the part designated by reference numeral 2302 is a magnetic field sense direction. The part designated by reference numeral 2303 is a magnetic sensing element, the part designated by reference numeral 2304 is a relative movement direction, the part designated by reference numeral 2305 is a magnetization direction, the part designated by reference numeral 2314 is a magnetization part, and the part designated by reference numeral 911 is a magnet. In FIG. 24, reference numeral 2400 denotes a magnetic sensor. The magnetic sensor 2400 includes a medium sense surface 2401, a soft magnetic material 2402, a magnetic shield member 2403, a non-magnetic substrate 2404, a holder 2410, a magnetization substance 2414, a bias magnet 2493, and terminals 24.

Bias magnetic fields in the same direction are applied to the two elements to perform differential detection therebetween to thereby remove a noise magnetic field thus to sense a magnetic field from the medium with good accuracy. This sensor can provide magnetic information which does not exist in the prior art, and exhibits validity particularly in security purpose of discrimination of bill, etc. However, since this sensor is configured to sense residual magnetic quantity after magnetization, the sensor has the disadvantage in detection of a medium having less residual magnetic quantity such as soft magnetic material, etc.

On the contrary, there is proposed a sensor capable of quantitatively detecting even soft magnetic material (Japanese Patent Application Laid-Open No. 2006-184201). This sensor has a configuration in which an element is disposed on a plane passing through the middle point of the NS axis of a magnet so that no magnetic field is applied in a magnetic field sense direction. Thus, a magnetic field detection element of which usable magnetic field range is narrow although it has high sensitivity can be used in the vicinity of the magnet without lowering the characteristic.

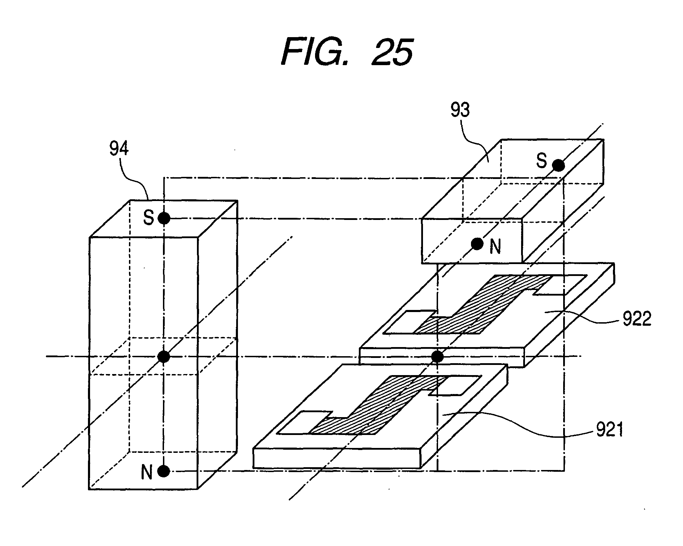

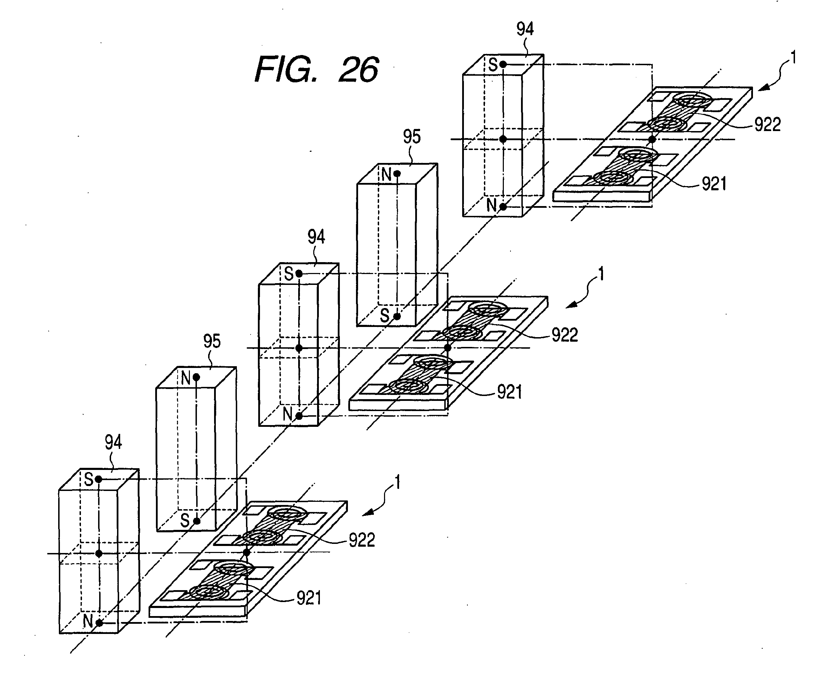

For this reason, magnetic quantity detection can be made with high accuracy even in the case of soft magnetic material. Moreover, compactization can be also realized. In the case where a magnetoimpedance element is used in this sensor, bias magnetic fields in the same direction are applied to two elements 921, 922 by a bias magnet 93, etc. as illustrated in FIG. 25. Differential detection therebetween allows to remove a noise magnetic field and sense a magnetic field from the medium with good accuracy. The part designated by reference numeral 94 is a magnet. In Japanese Patent Application Laid-Open No. 2006-184201, there is proposed a line sensor in which such sensors are arranged as illustrated in FIG. 26.

The configuration in which a magnetic field detection element is arranged on a plane passing through the middle point of the NS axis of a magnet is optimum for a magnetic field detection element having sensitivity at zero magnetic field and requiring no bias magnetic field, such as, for example, orthogonal fluxgate element. On the other hand, in the case of the magnetic field detection element which requires a bias magnetic field, a bias magnet 93 as illustrated in FIG. 25 or bias coil, etc. is required. Such magnetic filed detection element is disadvantageous in terms of its size and cost.

In addition, since a magnetic field having several hundred Oersted is formed in the vicinity of the magnet, when the magnet is closely disposed for compactization, it becomes difficult for the magnetoimpedance element, etc. of which usable magnetic field range is narrow to set a suitable bias magnetic field. Particularly, in the case of a line sensor, etc., it is necessary to suppress characteristic unevenness of individual sensors. As a result, a sensor capable of easily adjusting a bias magnetic field in accordance with the element characteristic is required.

Document US 6,310,475 B1 a magnetic substance detection sensor as defined in the preamble of claim 1. In particular, this magnetic substance detection sensor comprises a magnetism detecting element and a bias magnet.

Document US 5,512,822 A discloses a magnetic sensor, in which a magnet with a counterpart yoke is provided. Furthermore, magneto resistive sensors for detecting a magnetic field are provided.

### SUMMARY OF THE INVENTION

An object of the present invention is to provide a magnetic substance detection sensor which permits a high sensitivity magnetic field detection element to be effectively operative even in the vicinity of a magnet thus to permit quantitative detection without depending upon the magnetic characteristic of a medium, e.g., soft magnetic material, etc., and which is compact and permits reduced space, and which has high productivity. In addition, another object of the present invention is to provide a compact and high performance magnetic substance detecting apparatus.

This object is solved by a magnetic substance detection sensor as set out in claim 1.

Furthermore, according to the present invention, a magnetic substance detecting apparatus as set out in claim 13 is provided.

Moreover, according to the present invention, an input device as set out in claim 15 is provided.

Advantageous developments are defined in the dependent claims.

Further features of the pesent invention will become apparent from the following description of exemplary embodiments with reference to the attached drawings.

### BRIEF DESCRIPTION OF THE DRAWINGS

FIGS. 1A and 1B are perspective views illustrating an exemplary embodiment of the present invention.

FIG. 2A, 2B, 2C, 2D, 2E and 2F are plan views for describing the principle of the operation of the present invention.

FIGS. 3A , 3B and 3C are graphical diagrams for describing the principle of the operation of the present invention.

FIGS. 4A, 4B, 4C, 4D, 4E, 4F, 4G and 4H are diagrams illustrating the element characteristics and the setting ranges of bias magnetic field in the case where a magnetoimpedance element is used as a magnetic field detection element.

FIGS. 5A, 5B, 5C, 5D, 5E, 5F, 5G, 5H and 5I are plan diagrams illustrating examples of arrangement of magnet and magnetic field detection element according to the present invention.

FIGS. 6A, 6B, 6C, and 6D are circuit diagrams each illustrating a driving circuit according to the present invention.

FIGS. 7A, 7B, 7C, 7D and 7E are diagrams illustrating an example of movement direction of medium and output signal according to the present invention.

FIGS. 8A and 8B are diagrams illustrating an example of a magnetic substance detection sensor according to the present invention.

FIGS. 9A, 9B, 9C and 9D are perspective diagrams each illustrating a mounting example of magnet and magnetic field detection element in the example of the present invention.

FIG. 10 is a block diagram illustrating an encoder as one example of a magnetic substance detecting apparatus according to the present invention.

FIGS. 11A and 11B are block diagrams each illustrating a magnetic quantity detecting apparatus as an example of the magnetic substance detecting apparatus according to the present invention.

FIG. 12 is a block diagram illustrating a displacement detecting apparatus as an example of the magnetic substance detecting apparatus according to the present invention.

FIG. 13 is a block diagram illustrating a magnetic particle number detecting apparatus as an example of the magnetic substance detecting apparatus according to the present invention.

FIGS. 14A and 14B are block diagrams each illustrating a magnetism discrimination apparatus as an example of the magnetic substance detecting apparatus according to the present invention.

FIG. 15 is a diagram illustrating an example of a magnetic substance detection sensor used in the apparatuses of FIGS. 14A and 14B.

FIG. 16 is a diagram illustrating an example of magnetic substance detection sensor used in a two-dimensional magnetic distribution detecting apparatus as an example of the magnetic substance detecting apparatus according to the present invention.

FIGS. 17A and 17B are diagrams each illustrating a two-dimensional magnetic distribution detecting apparatus as an example of the magnetic substance detecting apparatus according to the present invention.

FIG. 18 is a perspective view illustrating an arrangement example of magnetic field detection elements and magnets of the apparatuses of FIGS. 17A and 17B.

FIG. 19 is a diagram illustrating an example of sensor configuration of each apparatus of FIGS. 17A and 17B.

FIGS. 20A, 20B, 20C and 20D are diagrams each illustrating an example of magnetic substance detection sensor used in an apparatus of FIG. 21.

FIG. 21 is a diagram illustrating another example of a two-dimensional magnetic distribution detecting apparatus as example of magnetic substance detecting apparatus according to the present invention.

FIG. 22 is a block diagram illustrating an example of signal processing of FIG. 21.

FIG. 23 is a plan view illustrating an example according to the prior art.

FIG. 24 is a perspective view illustrating the example according to the prior art.

FIG. 25 is a perspective view illustrating another example according to the prior art.

FIG. 26 is a perspective view illustrating a line sensor according to the prior art of FIG. 25.

FIGS. 27A, 27B and 27C are perspective views each illustrating an exemplary embodiment of the present invention.

FIGS. 28A, 28B and 28C are plane diagrams for describing the principle of the operation of the present invention.

FIG. 29 is a graphical diagram illustrating element characteristic according to the present invention.

FIGS. 30A, 30B, 30C and 30D are diagrams illustrating difference of impedance of magnetic field detection element by the proximity method of medium according to the present invention.

FIGS. 31A, 31B, 31C and 31D are diagrams for describing movement of magnetic substance detection sensor and medium according to the present invention.

FIG. 32 is a perspective view illustrating a second exemplary embodiment of a magnetic substance detection sensor according to the present invention.

FIGS. 33A and 33B are diagrams for describing the principle of the operation of the exemplary embodiment of FIGS. 8A and 8B.

FIGS. 34A, 34B and 34C are graphical diagrams for describing the principle of the operation of the exemplary embodiment of FIGS. 8A and 8B.

FIGS. 35A and 35B are diagrams illustrating an example of magnetic substance detection sensor according to the present invention.

FIGS. 36A and 36B are perspective views each illustrating an arrangement example of magnet and magnetic field detection element according to the present invention.

FIG. 37 is a perspective view illustrating a magnetic substance detection sensor used in an encoder of FIG. 38.

FIG. 38 is a block diagram illustrating another example of the encoder according to the present invention.

FIGS. 39A and 39B are diagrams illustrating shift in terms of time of an output signal with respect to movement of medium in FIG. 38.

FIG. 40 is a perspective view illustrating an example of a magnetic substance detection sensor suitable in the case where magnetic quantity of medium is small and noise magnetic field such as earth magnetism, etc. is large in FIG. 38.

FIG. 41 is a perspective view illustrating an example of an input device according to the present invention.

FIG. 42 is a perspective view illustrating another example of an input device according to the present invention.

FIG. 43 is a perspective view illustrating a third exemplary embodiment of the present invention.

FIGS. 44A, 44B, 44C, 44D and 44E are diagrams for describing the principle of the operation of the exemplary embodiment of FIG. 43.

FIGS. 45A and 45B are graphical diagrams for describing the principle of the operation of the exemplary embodiment of FIG. 43.

FIGS. 46A, 46B, 46C and 46D are diagrams each illustrating an arrangement example of magnet and magnetic field detection element of magnetic substance detection sensor according to the present invention.

FIGS. 47A, 47B, 47C, 47D and 47E are diagrams each illustrating an example of movement direction of medium and output signal in the case where the magnetic substance detection sensor of FIG. 43 is used.

FIGS. 48A and 48B are diagrams each illustrating a mounting example of a magnet 12 and a magnetic field detection element 130 of a magnetic substance detection sensor according to the present invention.

FIGS. 49A, 49B, 49C and 49D are diagrams illustrating examples of magnetic substance detection sensor.

### DESCRIPTION OF THE EMBODIMENTS

(First exemplary embodiment)

The best mode for carrying out the invention will now be described in detail with reference to the attached drawings. The present invention is directed to a magnetic substance detection sensor including a magnet producing a magnetic field and a magnetic field detection element for detecting change of magnetic field. In the magnetic substance detection sensor of the present invention, the magnetic field detection element is disposed on a plane intersecting with the NS axis of the magnet at a point except for the middle point thereof with the NS direction of the magnetic being as normal so that the magnetic field detection direction becomes in parallel to the plane, and a bias magnetic field is formed from the magnet.

Moreover, the magnetic field detection element has a magnetic thin film, and is such that the magnetic field detection direction is in parallel to the film surface of the magnetic thin film. The magnetic field detection direction thereof is disposed in a manner inclined from a radial direction of the NS axis. The magnetic field detection element detects a magnetic field change when a magnetic substrate becomes close to the N-pole or S-pole of the magnet. The bias magnetic field is disposed at a position which is set within the region where magnetization of the magnetic field detection element is saturated.

Further, there are at least two magnetic field detection elements. These magnetic field detection elements are disposed linear-symmetrically with respect to a single straight line on a plane intersecting with normal on the plane. These magnetic detection elements output a signal corresponding to sum of outputs of the two magnetic field detection elements. The two magnetic field detection elements are connected in series. A voltage generated across both ends of the connected two magnetic field detection elements is detected. The signal thus detected is output.

Furthermore, the magnetic substance detection apparatus of the present invention performs detection of magnetic substance by using a magnetic substance detection sensor or magnetic substance detection line sensor. The magnetic substance detection apparatus of the present invention outputs a signal corresponding to a difference between an output before magnetic substance is detected and an output in detecting the magnetic substance in the magnetic substance detection sensor.

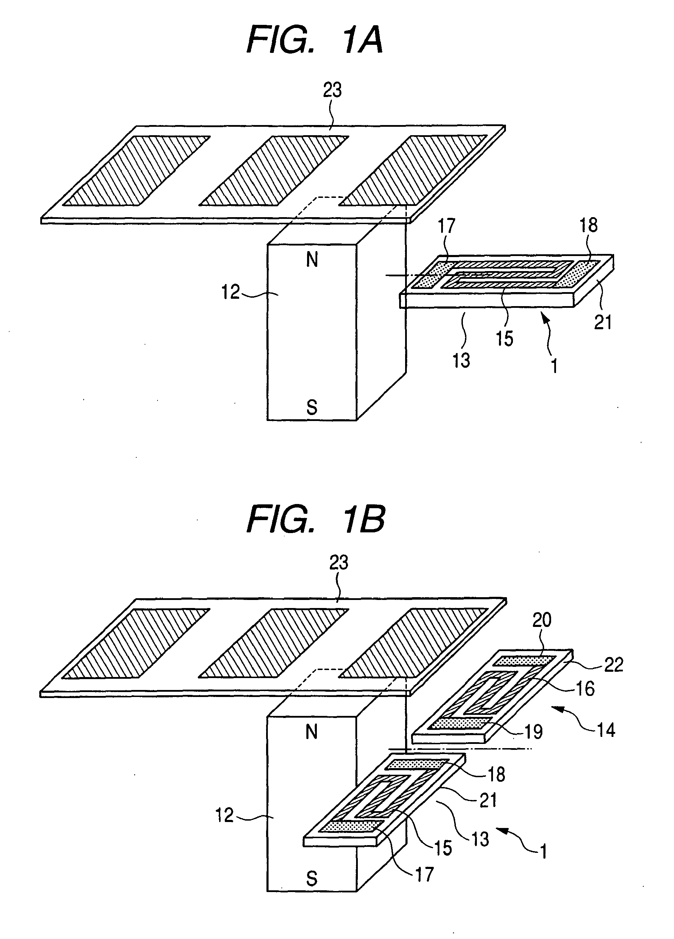

FIG. 1A illustrates the fundamental configuration of a magnetic substance detection sensor of the present invention. FIG. 1B illustrates the configuration used for high precision detection (including two magnetic field detection elements). The magnetic substance detection sensor 1 includes a magnet 12 and magnetic field detection elements 13, 14, wherein these magnetic field detection elements 13, 14 are disposed on a plane passing through the part between the middle point of the NS axis and the N-pole with the NS axis of the magnet 12 being as normal.

The magnetic field detection element 13 includes a magnetic film 15 formed on a non-magnetic substrate 21 and electrodes 17, 18; and the magnetic field detection element 14 includes a magnetic film 16 formed on a non-magnetic substrate 22, and electrodes 19, 20. Each length direction of the magnetic film is caused to be in correspondence with the magnetic field detection direction. A medium 23 containing magnetic material becomes close to the N-pole of the magnet 12 to detect a magnetic field change in that instance by magnetic field detection elements 13, 14.

It is most desirable that the magnetic field detection elements 13, 14 are magnetoimpedance elements. However, any magnetic field detection element operative under a bias magnetic field may be used. Particularly, there is no restriction thereof. A magnetic field detection element such as GMR, etc. may be also employed. The magnetic field detection elements 13, 14 undergo a strong magnetic field in an NS direction of the magnet 12. In this case, it is most desirable to form such element by a thin film having a large demagnetizing field in order to suppress the influence thereof.

For non-magnetic substrates 21, 22 for forming magnetic field detection elements, there may be used a glass, ceramic or silicon substrate, etc. It is desirable to select a substance having coefficient of thermal expansion close to that of a magnetic film to be formed. While magnetic films 15, 16 are formed in a zigzag form in which three magnetic patterns are connected in FIGS. 1A and 1B, such an implementation is only one example. If there is employed a magnetic film pattern having the magnetic field detection direction which is the same in two magnetic field detection elements, and approximately the same sensitivity to be obtained, there is no limitation in particular. There is no particularly limitation in arrangement or shape also with respect to the electrodes 17, 18, 19, 20.

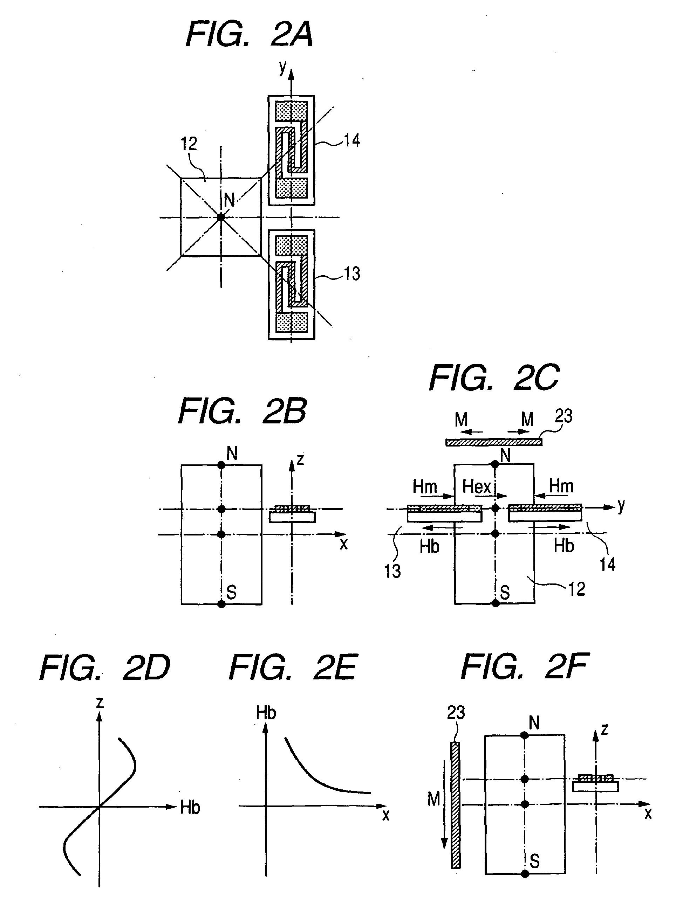

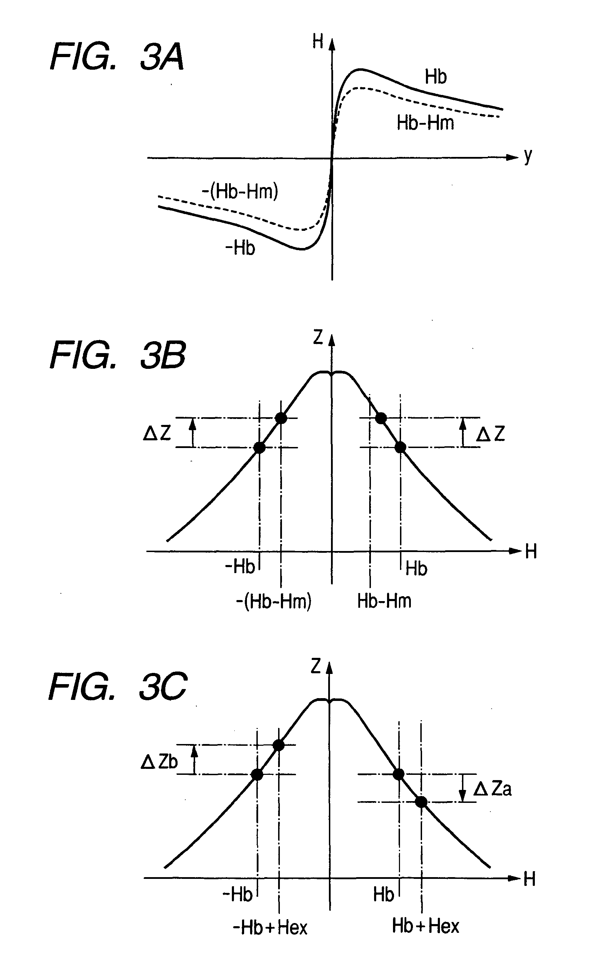

The detection principle of the present invention will now be described with reference to FIGS. 2A to 2F and FIGS. 3A to 3C. While the configuration of FIG. 1B effective for high precision detection will be described as an example in the following description, the operation of the magnetic field detection element is similar also in the configuration of FIG. 1A. In FIGS. 2A to 2F, the y-direction of the magnetic field detection elements 13, 14 is the magnetic field detection direction, and impedance is changed in accordance with the y-direction component of a magnetic field to be applied. Here, FIG. 2A is a view when FIG. 1B is viewed from the upper direction, FIG. 2B illustrates a view when FIG. 1B is viewed from the side surface, and FIG. 2C illustrates a view when FIG. 1B is viewed from the front face.

The magnetic field detection elements 13, 14 undergo bias magnetic fields Hb in the directions opposite to each other from the magnet 12. Further, the magnitude of the bias magnetic field can be successively and gently changed as shown in FIGS. 2D and 2E by moving the magnetic field detection element in the direction in parallel to the NS axis of the magnet 12 (z-direction of FIG. 2B) and the direction perpendicular to the NS axis (x-direction of FIG. 2B)).

Moreover, the magnetic field detection direction is disposed in a manner to take an angle relative to the radial direction of the NS axis, thereby allowing particularly a change of the bias magnetic field by movement in the z-direction to be gentle. By employing such an approach, the magnetic field detection element for which bias setting is required can be effectively used.

In FIG. 2C, the medium 23 becomes close to the magnetic pole surface of the magnet 12. As a result, the medium 23 is symmetrically magnetized with respect to the NS axis so that magnetic field detection elements 13, 14 undergo magnetic fields Hm in the directions opposite to each other. While it is most desirable to allow the medium 23 to become close to the magnetic pole surface, even if it is caused to become close thereto in parallel to the NS axis as illustrated in FIG. 2F, magnetic field change similar to FIG. 2C can be detected.

FIG. 3A is a magnetic field distribution by position of magnetic field detection direction. In dependency upon presence or absence of the medium 23, change is performed from the distribution of solid-line to the distribution of dotted line. The magnetic field detecting elements 13, 14 are arranged at a position where change is small except for the part in the vicinity of the center of this magnetic field distribution. FIG. 3B illustrates an example of the element characteristic. This element has the characteristic expressed as even function with respect to the magnitude of a magnetic field, and is such that its output monotonously decreases.

In the state where there is no medium 23, bias points of the magnetic field detection elements 13 and 14 are located at positions of-Hb and Hb. By proximity of the medium 23, those bias points respectively shift to -(Hb - Hm) and (Hb - Hm). Impedance change ΔZ at this time of the magnetic field detection element 13 and that of the magnetic field detection element 14 are the same. By taking sum of those impedance changes, change of 2ΔZ can be obtained.

FIG. 3C illustrates change in the case where an external magnetic field Hex is applied. The element characteristic and the bias points are those similar to FIG. 3B. The bias points of the magnetic field detection elements 13 and 14 respectively shift to -Hb + Hex and Hb + Hex. As a result, impedance outputs ΔZb and ΔZa are produced. If the external magnetic field is sufficiently small with respect to the linearity of the element characteristic, ΔZb + ΔZa become equal to zero.

By detecting sum of impedance values of the magnetic field detection elements 13, 14 in this way, the external magnetic field is cancelled so that only change by the medium 13 can be detected. This principle of detection is the same even in the case where the NS pole of the magnet is opposite.

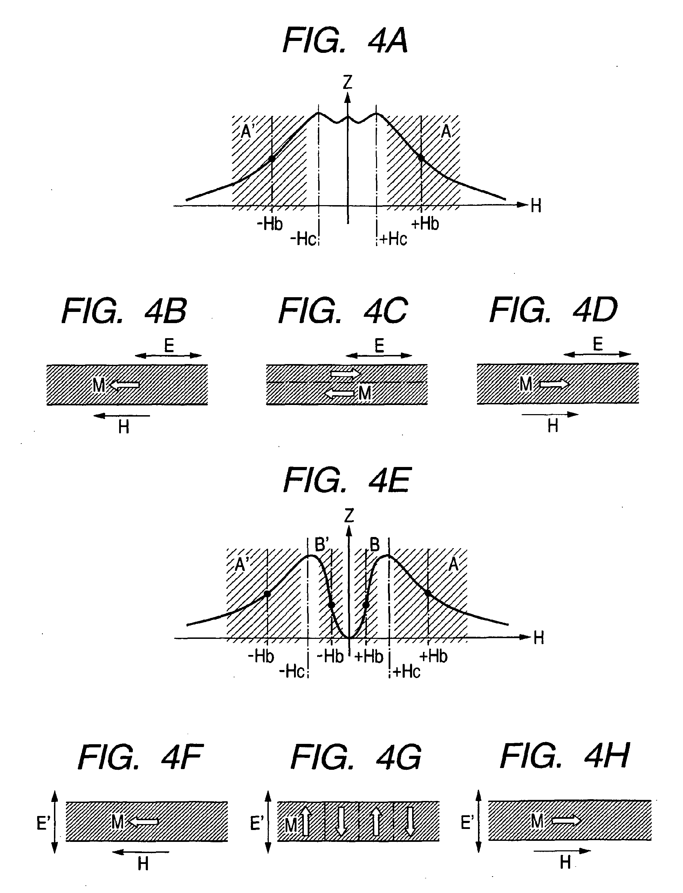

FIGS. 4A to 4H illustrate the element characteristics and the setting ranges of bias magnetic field in the case where a magnetoimpedance element is used as a magnetic field detection element. Moreover, the model diagrams of the magnetic domain structure of magnetic film are illustrated below the graphs. FIGS. 4B, 4C and 4D respectively correspond to the range less than -Hc, the range from -Hc to +Hc, and the range more than +Hc in FIG. 4A. FIGS. 4F, 4G and 4H respectively correspond to the range less than -Hc, the range from - Hc to +Hc, and the range more than +Hc in FIG. 4E. The magnetic field detection direction is the pattern length direction of the magnetic film. The graph of FIG. 4A indicates the magnetic field-impedance characteristic obtained when magnetic anisotropy is given to the pattern length direction (E direction in FIGS. 4B to 4D). At this time, within the range of ±Hc where zero magnetic field is caused to be center, the magnetic film takes a magnetic domain structure in which regions having magnetizations in directions opposite to each other along the E-direction are mixed. Within the region above ±Hc, there grows a magnetization region in the direction of applied magnetic field H to take the structure in which magnetizations M are in alignment with each other.

The graph of FIG. 4E is the characteristic obtained in the case where magnetic anisotropy is given to the pattern width direction (E' direction in FIGS. 4F to 4H). Also in this case, within the range of ±Hc where zero magnetic field is caused to be center, the magnetic film similarly takes a magnetic domain structure in which regions having magnetizations in directions opposite to each other along the E' direction are mixed. Within the region above ±Hc, magnetization is rotated toward the direction of applied magnetic field H to take the structure in which magnetizations M are in alignment with each other. Ordinarily, the magnetoimpedance element is used in the characteristic of FIG. 4E, and bias magnetic field Hb is set within the magnetic field range of B or B' indicated by hatching.

However, in this case, the width of the setting range is very narrow, and takes about 2 to 3 Oe at the maximum. On the contrary, when the bias magnetic field is set within the magnetic field range of A or A', the sensitivity is lowered, but the range where sensitivity unevenness similar to B or B' can be obtained is greatly enlarged so that it is widened to the width of 10 to 20 Oe. Also when the bias magnetic field is set within the magnetic field range of A or A' in the characteristic of FIG. 4A, such a phenomenon similarly takes place. Since the bias point is determined by arrangement of the magnetic field detection element with respect to the magnet in the configuration of FIGS. 2A to 2F, position accuracy of the arrangement for setting the bias magnetic field at a reasonable bias point can be greatly relaxed within the magnetic field range of A or A'. In the configuration of FIG. 1B, e.g., the magnetic field detection element 13 can set the bias magnetic field Hb within the magnetic field range of A, and the magnetic field detection element 14 can set the bias magnetic field Hb within the magnetic field range of A'.

Since magnetization within the magnetic film is saturated substantially in magnetic field detection direction within the magnetic field range of A or A', even if an external magnetic field varies, hysteresis or noises followed by the movement of a magnetic wall is difficult to take place. For this reason, although the sensitivity is lowered, there is no great lowering of the characteristic in terms of sensitivity/noise ratio.

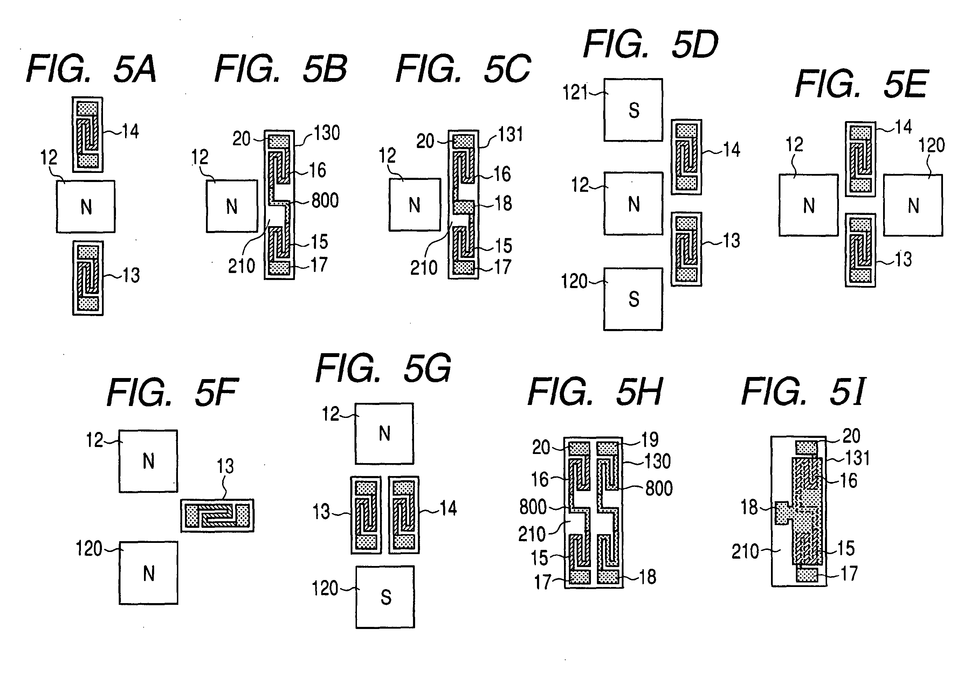

FIGS. 5A to 5I illustrate examples of arrangement of magnet and magnetic field detection element. As the arrangement of the magnetic field detection element, there may be also employed, in addition to the arrangement of FIG. 2A, the configuration in which the magnetic field detection elements 13, 14 are disposed on both sides of the magnet 12 as shown in FIG. 5A. Moreover, there may be employed an arrangement using a magnetic field detection element 130 in which the magnetic films 15, 16 are formed on the same substrate 210 as shown in FIG. 5B to connect those magnetic films in series by a conductive pattern 800.

It is to be noted that since magnetic field is greatly changed by arrangement error of the magnetic field detection elements 13, 14 with respect to the magnet 12 in the configuration of FIG. 5A, the configurations of FIGS. 2A and 5B having small magnetic field gradient with respect to position change of the magnetic field detection element are desirable. Moreover, in the case where the characteristic check, etc. is performed in inspection process of manufacture, there is desired the configuration of FIG. 5C in which a middle point electrode 18 is provided to have ability to individually evaluate the two magnetic field detection elements 13, 14.

FIG. 5D illustrates the configuration using auxiliary magnets 120, 121. FIG. 5E illustrates the configuration using the auxiliary magnet 120. Both configurations are also an arrangement for applying a magnetic field to a medium in order to enhance magnetic field detection direction components of magnetic field detection elements of magnetization taking place in the medium, and effectively act on a medium having large residual magnetization before detection, etc. In the case of this configuration, since magnetic field change due to positional shift of the elements becomes extremely large as compared to the case where the auxiliary magnet 120 or 121 does not exist, the present invention which can relax position accuracy is very effective.

Also in configurations of FIGS. 5F, 5G, the auxiliary magnet 120 is used. FIG. 5F illustrates the configuration in which a single magnetic field detection element is provided. This configuration is a configuration adapted to securely magnetize a medium to permit a stable detection while allowing the magnetic field detection direction to have an angle from the radial direction of the NS axis. In the case of detecting gradient of magnetic quantity, there may be also employed, as shown in FIG. 5G, a configuration in which the magnetic field detection elements 13, 14 are disposed between two magnets of the magnet 12 and the auxiliary magnet 120 as shown in FIG. 5G. Since bias magnetic fields are applied with respect to two elements in the same direction in this configuration, ordinary differential detection is performed.

FIGS. 5H and 5I illustrate examples of the configuration of the magnetic field detection element. FIG. 5H illustrates the example where a conductive pattern 800 such as Cu, etc. is formed on a substrate 210 where a magnetic film is formed. When there is employed a method of adjusting film thickness, etc. so as to take a resistance value to the same degree as resistance value of the magnetic film, this magnetic field detection element can be used as a resistor for cancellation of noises due to electrostatic capacity. FIG. 5I illustrates the example where the magnetic film is covered by a conductive film with an insulating film (not shown) therebetween. When the electrode 18 is grounded, the magnetic field detection element of this configuration functions as an electric shield.

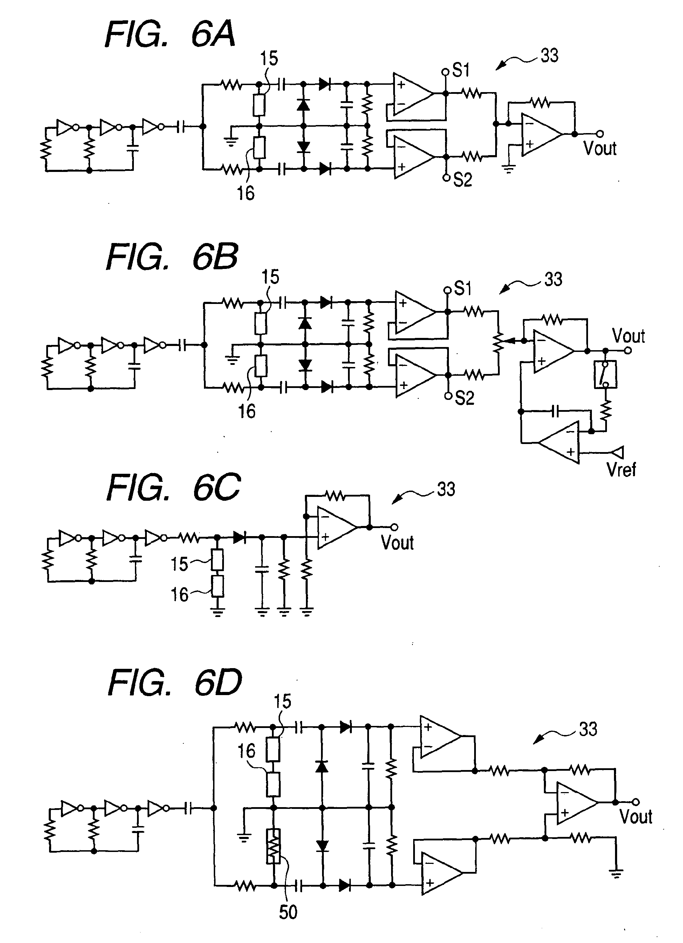

FIGS. 6A to 6D illustrate driving circuits in the case where a magnetoimpedance element is used as the magnetic field detection element. The oscillation unit is a pulse oscillation circuit using CMOS. This circuit configuration is the most desirable, but is not particularly limited to such circuit configuration. A pulse current is caused to flow in the element as a current alternately swinging in positive and negative directions through AC coupling to advantageously reduce hysteresis of the magnetic film.

While the detecting circuit has a configuration using diode, the detecting circuit may be similarly configured even with a method using switch. The driving circuit of FIG. 6A may be applied to the configurations of FIGS. 2A to 2F, and FIGS. 5A and 5C. Respective one electrodes of two magnetic field detection elements 13, 14 are grounded. Thus, outputs corresponding to respective impedance values are added after detection. An added output thus obtained is output as Vout.

In this circuit, by performing detection of the two magnetic field detection elements thereafter to monitor outputs S1, S2, balance or sensitivity unevenness of a bias magnetic field, or unsatisfactory operation, etc. can be individually tested by the two magnetic field detection elements.

The driving circuit of FIG. 6B is a circuit configuration in which the balance adjustment function and reset function of offset are added to FIG. 6A. In the case where there exists any sensitivity unevenness of two magnetic field detection elements, such sensitivity unevenness is compensated by the balance adjustment function. The reset function is used for correction of output level change by the temperature characteristic of diode or detection of comparison with a reference medium.

FIG. 6C illustrates an example in which two magnetic field detection elements are connected in series to permit driving operation by a circuit corresponding to prior art single element. This circuit is a circuit which has exhibited the configuration of the present invention at the maximum. The circuit scale can be reduced as compared to the prior art.

FIG. 6D is a circuit effective in the case where there is influence of electrostatic capacity by drawing of cable, etc. When a resistor 50 of the same order of resistance value of two magnetic field detection elements is disposed in the vicinity of the magnetic field detection element, etc., noises by electrostatic capacity are removed so that high accuracy detection can be made.

A method of detecting a medium will now be described. Detection of a medium may be performed in the state where the medium is stopped, and may be continuously performed while moving the medium relative to a sensor. In the case where there is employed a method of moving a medium in parallel to a magnetic pole surface of a magnet to successively detect the medium, it is desirable to move the medium in the direction perpendicular to the magnetic field detection direction of the magnetic field detection element.

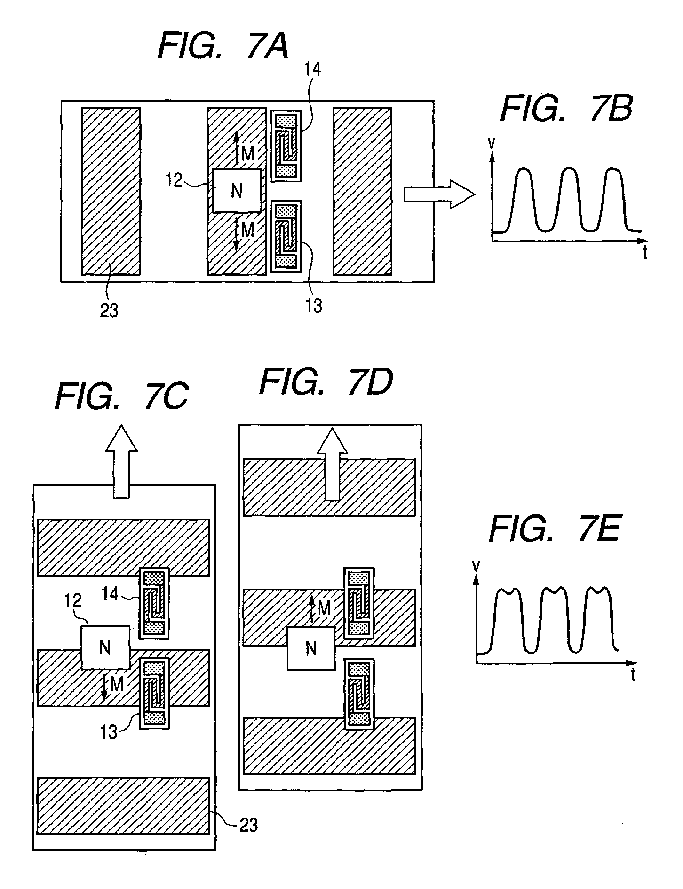

FIGS. 7A to 7E illustrate examples of movement direction of medium and output signal. FIGS. 7A and 7B illustrate output examples in the case where a stripe-shaped medium is moved in the direction perpendicular to the magnetic field detection direction of the magnetic field detection element. In this movement direction, a mount corresponding to magnetic quantity of pattern is detected. On the contrary, an output in the case where such a medium is moved in parallel to the magnetic field detection direction results in outputs as shown in FIGS. 7C to 7E. When the pattern becomes fine, two peaks will appear with respect to a single pattern.

Except for the case where the magnetic field detection direction is limited for the purpose of avoiding a noise magnetic field from the carrying system for a medium such as motor, etc., it is desirable to move a medium in the direction perpendicular to the magnetic field detection direction as illustrated in FIGS. 7A and 7B.

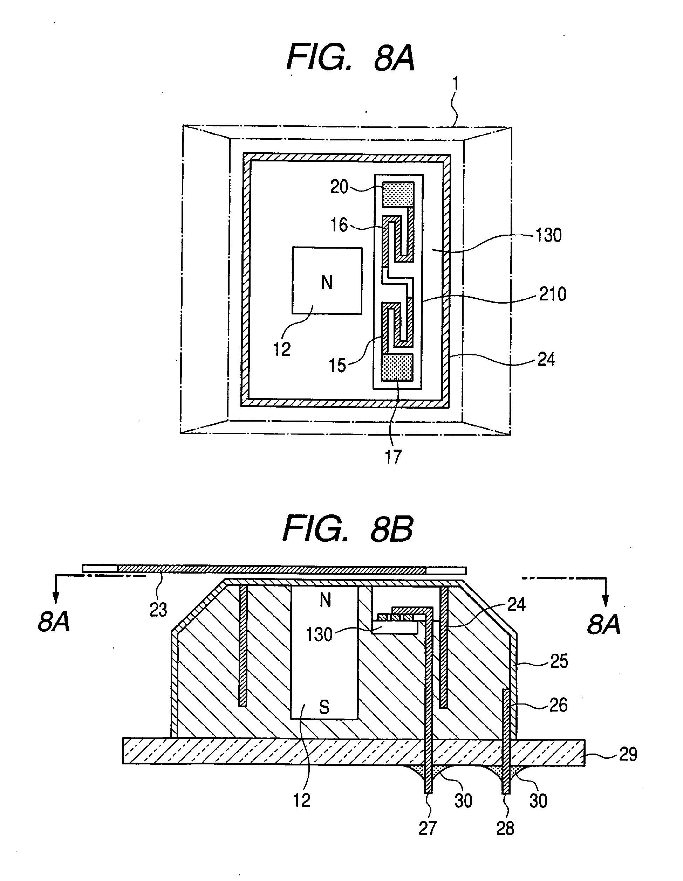

Practical example of the first exemplary embodiment will now be described. FIGS. 8A and 8B illustrate a magnetic substance detection sensor according to the present example. In FIGS. 8A and 8B, there are respectively illustrated the diagram when the inside of the magnetic substance detection sensor 1 is viewed from the upper direction, and the diagram when it is viewed from the side surface. A magnet 12, a magnetic field detection element 130 and a shield 24 are integrally held within a holder 26, and disposed within a case 25. The outer appearance of the case has dimensions of about 6 × 6 × 3 mm³. More miniaturized configuration can be realized as compared to the prior art.

As the magnet 12, there is used neodymium magnet having magnetic pole area of 1 mm × 1 mm and height of 1.6 mm. On the case surface opposite to a medium 23, a magnetic field having about 1K Oe is produced. The spacing between the magnet 12 and the magnetic field detection element 130 is 0.3 mm. The magnetic field detection element 130 is disposed at a position of height of 0.6 mm from the plane of the magnetic pole opposite to the medium 23 with accuracy of error of 0.1 mm. A bias magnetic field of 20 to 40 Oe is applied.

The magnetic field detection element 130 is adapted so that magnetic films 15, 16 are formed on a substrate 210, and both magnetic films are connected in series so that electrodes 17, 20 are respectively formed on both sides thereof. As the substrate 210, there is used a ceramic substrate of calcium titanate having thickness of 0.2 mm. The magnetic films 15, 16 are formed by forming, as film, Fe-Ta-C based magnetic material having positive magneto-striction by sputtering process thereafter to perform processing thereof by ion milling so as to take a zigzag shape such that patterns having width of 30 µm, length of 1 mm and film thickness of 1800 nm are connected.

Cu is used for connection between the electrodes 17, 20 and the magnetic films 15, 16, and is formed by the lift-off process. A protective film (not shown) is formed on the substrate except for electrodes by the spin-coat process and the photolithographic process in a manner to cover the magnetic film. The electrodes 17, 20 are electrically connected to an external driving circuit board 29 by means of a terminal 27. When a high frequency current is applied to the magnetic field detection element 130 through the terminal 27, this magnetic field detection element operates as a magnetoimpedance element.

The shield 24 is formed by 78 % Ni permalloy plate having plate thickness of 0.25 mm, and is disposed so as to surround the magnetic field detection element 130 and the magnet 12. The case 25 is formed by phosphor bronze having thickness of 0.2 mm, wherein electroless Ni plating is implemented to the surface opposite to the medium 23. The case 25 is electrically connected to the ground of the external driving circuit board 29 by means of a terminal 28. The part designated by reference numeral 30 is solder.

Since the magnetoimpedance element is used as magnetic field detection element in this example, the magnetic field detection sensitivity is high, whereas the range where satisfactory linearity can be obtained in the magnetic field-impedance characteristic is narrow. When the sensitivity is above the range, canceling effect with respect to a noise magnetic field at the two magnetic field detection elements is lowered.

For this reason, reduction of the noise magnetic field by the magnetic shield 24 exhibits a great advantage in improvement of detection accuracy of a medium. Moreover, since high frequency current is used, there are instances where there may take place an offset in a sensor output by electrostatic capacity with respect to the medium. The case 25 also has a function as an electric shield thus to stabilize the operation of the magnetic field detection element.

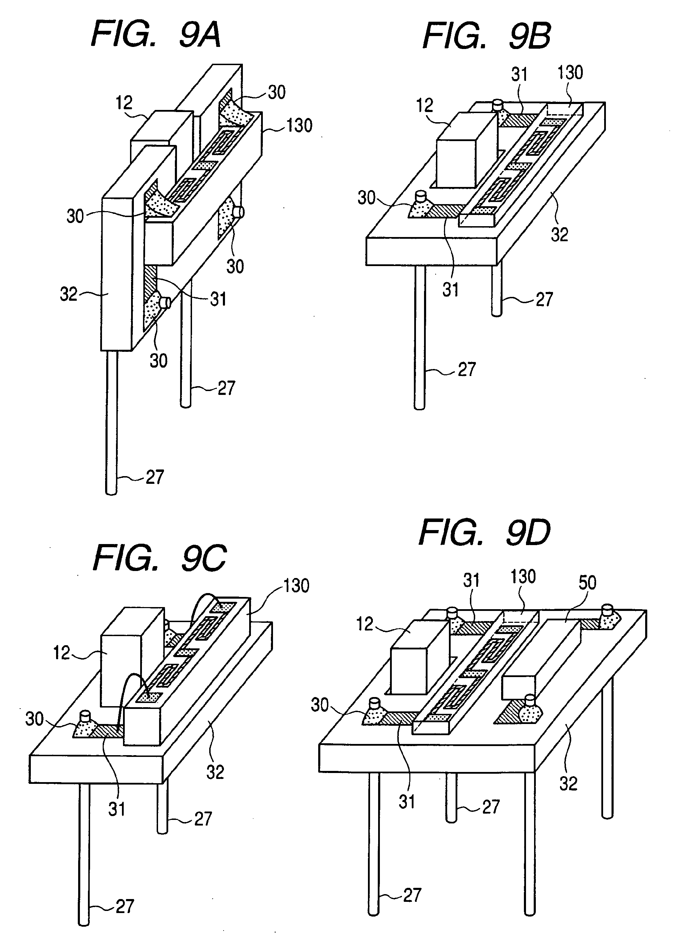

FIGS. 9A to 9D illustrate another example of a method of mounting a magnet 12 and a magnetic field detection element 130. In the example of FIG. 9A, the magnetic field detection element 130 is mounted on a printed circuit board 32 by means of solder 30 that it bridges over the printed circuit board 32. The both ends of the magnetic field detection element 130 are connected to an external driving circuit by means of the terminals 27. The magnet 12 is fixed on the printed circuit board 32 by adhesive agent, etc. in the state where positioning with respect to the magnetic field detection element 130 is performed by using jig, etc.

In the example of FIG. 9B, the magnetic field detection element 130 is surface-mounted on the printed circuit board 32, and the magnet 12 is disposed at a hole of the printed circuit board 32. In the example of FIG. 9C, the magnet 12 and the magnetic field detection element 130 are mounted on the printed circuit board 32 by means of adhesive, etc., and position accuracy in the height direction is ensured by the thickness of the board of the magnetic field detection element 130. Connection of the electrode is performed through wire-bonding process, etc. In FIGS. 9A to 9D, the part designated by reference numeral 31 is a copper wiring.

In the example of FIG. 9D, a resistor 50 used for cancellation of noises based on electrostatic capacity is mounted on a board where the magnetic field detection element 130 is mounted.

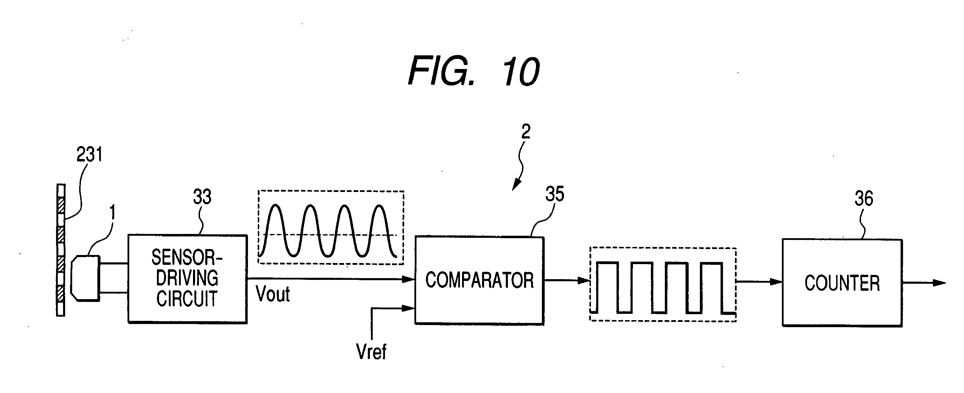

FIG. 10 illustrates an encoder as an example of the magnetic substance detecting apparatus using magnetic substance detection sensor of the present invention. In FIG. 10, the part designated by reference numeral 1 is a magnetic substance detection sensor, the part designated by reference numeral 2 is a magnetic substance detecting apparatus, and the part designated by reference numeral 33 is a driving circuit. As the magnetic substance detection sensor 1, e.g., the configurations of FIGS. 8A and 8B may be used. As the driving circuit 33, e.g., the circuit of FIG. 6C may be used. A medium 231 is adapted so that magnetic materials are disposed at predetermined intervals. A medium formed by print such as a pattern of magnetic thin film or magnetic ink, etc. may be employed in addition to a medium where magnetic materials are processed.

When the medium 231 is relatively moved with respect to the magnetic substance detection sensor 1, an output Vout is changed to pulsate an output change by a comparator 35 with reference voltage Vref being as a reference. Moreover, by counting its pulse signal by a counter 36, this magnetic substance detecting apparatus operates as an encoder.

The magnetic substance detection sensor of the present invention has sufficient sensitivity also with respect to a print medium such as magnetic ink, etc., and there is no limit in selection of the medium. In the case of a print medium, pitch and shape can be easily changed. Thus, a low cost and widely usable encoder can be constituted.

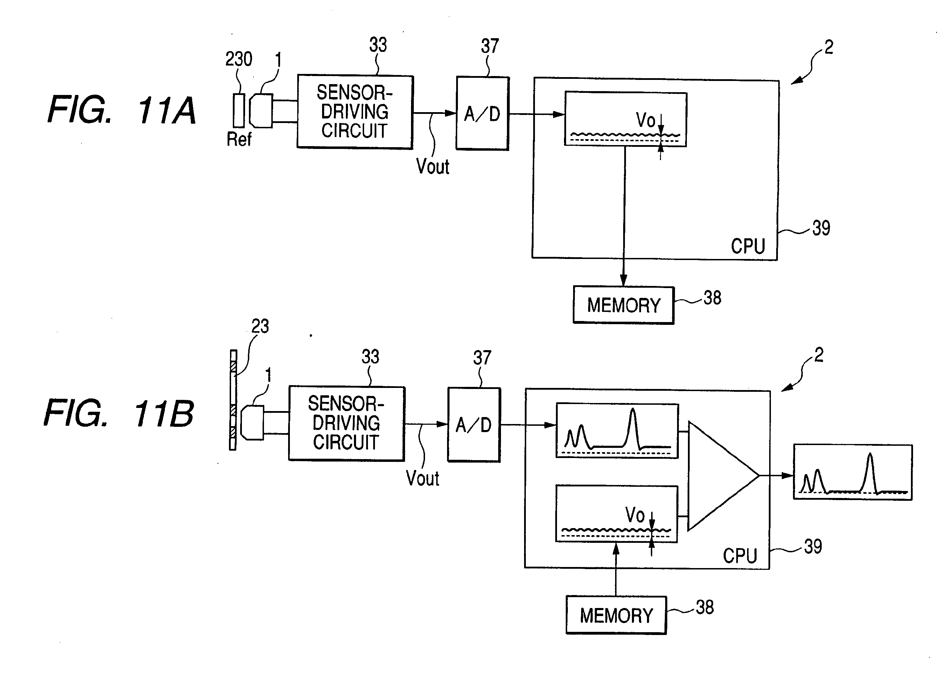

FIGS. 11A and 11B illustrate a magnetic quantity detecting apparatus as an example of the magnetic substance detecting apparatus using the magnetic substance detection sensor 1 of the present invention. In these figures, the part designated by reference numeral 1 is a magnetic substance detection sensor, the part designated by reference numeral 2 is a magnetic substance detecting apparatus, and the circuit component designated at reference numeral 33 is a driving circuit. As the magnetic substance detection sensor 1, e.g., the configurations of FIGS. 8A and 8B may be used. As the driving circuit 33, e.g., the circuit of FIG. 6C may be used.

The operation of the magnetic quantity detecting apparatus will be described below. First, a memory 38 is caused to store, as a digital signal, through an A/D converter 37, an output V₀ of the sensor-driving circuit 33 in the state a where reference medium 230 is close thereto as illustrated in FIG. 11A, or in the state where there is no medium 230. Thereafter, as shown in FIG. 11B, a medium 23 to be detected is caused to becomes close to the magnetic substance detection sensor 1 to calculate a difference between an output at that time and V₀ stored in the memory 38 to detect magnetic quantity. A CPU 39 performs an arithmetic processing in that case.

The magnetic substance detection sensor of the present invention outputs a signal corresponding to sum of impedance values of the two magnetic field detection elements. For this reason, when connection cable between the sensor unit and the driving circuit is long, etc., there are instances where offset of output may take place by the influence of coupling capacity with respect to the periphery. In this sense, detection of difference with respect to V₀ becomes effective means. Thus, a compact and high accuracy magnetic quantity detecting apparatus can be realized. If, e.g., the driving circuit of FIG. 6B is used, etc, signal processing similar to FIGS. 11A and 11B can be performed even with analog circuits.

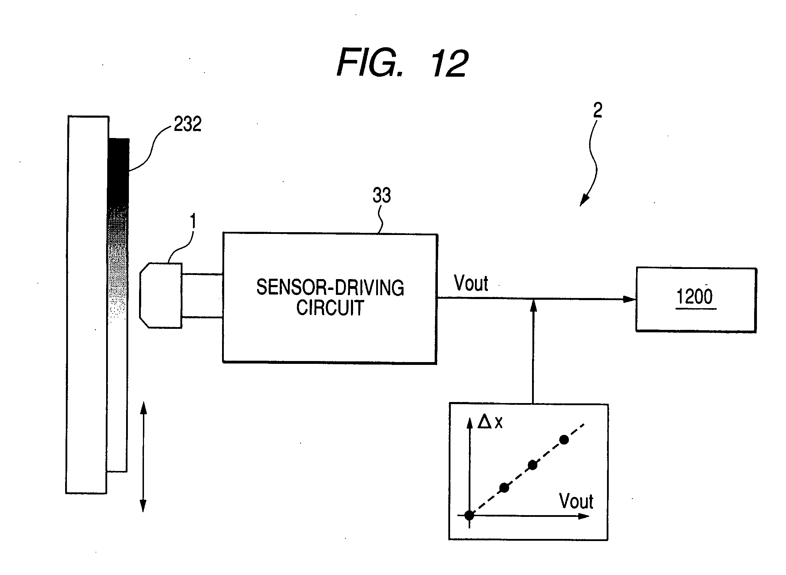

FIG. 12 illustrates a displacement detecting apparatus as an example of the magnetic substance detecting apparatus using the magnetic substance detection sensor of the present invention. The part designated by reference numeral 1 is a magnetic substance detection sensor. The part designated by reference numeral 2 is a magnetic substance detecting apparatus. The part designated by reference numeral 33 is a driving circuit. At the circuit component designated at reference numeral 1200, position is calculated. As the magnetic substance detection sensor 1, e.g., the configuration of FIGS. 8A and 8B may be used. As the driving circuit 33, e.g., the circuit of FIG. 6C may be used. In FIG. 12, gradation pattern in which density of magnetic material is changed is formed on a medium 232.

The medium 232 is fixed on an object moved relative to the magnetic substance detection sensor to detect magnetic quantity by the magnetic substance detection sensor to thereby have ability to detect the movement quantity of the object. In the configuration of FIG. 12, when V₀ at the time when an object is located at a certain position, displacement quantity with that position being as reference can be detected. The gradation pattern can be formed by print such as magnetic ink, etc., and change of density gradient or length of pattern is also easy. Thus, a low cost displacement detecting apparatus having high degree of freedom can be realized.

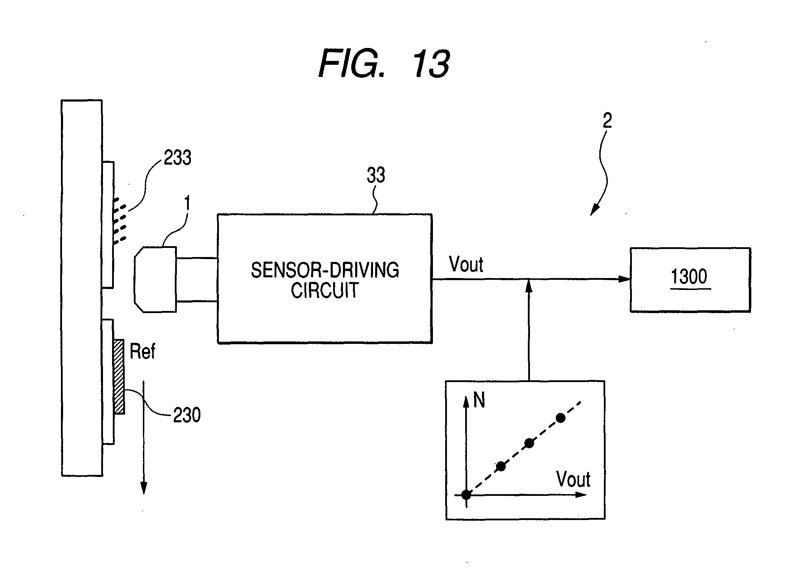

FIG. 13 illustrates a magnetic particle number detecting apparatus as an example of the magnetic substance detecting apparatus using the magnetic substance detection sensor of the present invention. The part designated by reference numeral 1 is a magnetic substance detection sensor, the part designated at reference 2 is a magnetic substance detecting apparatus, and the part designated by reference numeral 33 is a driving circuit. At the circuit component designated at reference numeral 1300, the number of particles is calculated. As the magnetic substance detection sensor 1, e.g., the configurations of FIGS. 8A and 8B may be used. As the driving circuit 33, e.g., the circuit of FIG. 6C may be used. This magnetic particle number detecting apparatus is suitable for detection, etc. of marker magnetic particles used in, e.g., medical diagnosis. Since magnetic field from magnetic particles are very weak, it is desirable to detect a difference between a reference medium 230 and a sample 233 to which magnetic particles are attached in the state where the sample 233 is caused to be successively close to the magnetic substance detection sensor 1.

By using the number of particles which has been created in advance from the output difference and calibration data of output, the number of particles is calculated. Since the magnetic substance detection sensor of the present invention can use a high sensitivity magnetic field detection element, detection in a non-contact state can be made. As a result, detection error based on attachment of particles can be reduced. Thus, a compact and high accuracy magnetic particle number detecting apparatus can be realized.

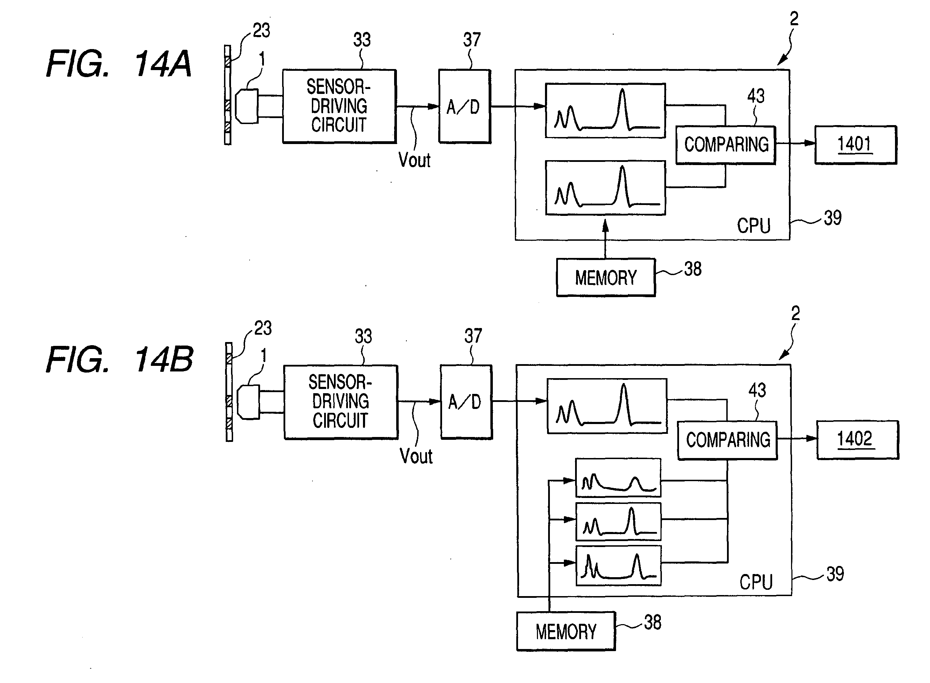

FIG. 14A and 14B illustrate a magnetism discrimination apparatus as an example of the magnetic substance detecting apparatus using the magnetic substance detection sensor of the present invention. The part designated by reference numeral 1 is a magnetic substance detection sensor, the part designated by reference numeral 2 is a magnetic substance detecting apparatus, and the part designated by reference numeral 33 is a driving circuit. At the circuit component designated at reference numeral 1401, an authenticity verification result is output. At the circuit component designated at reference numeral 1402, a kind determination result is output. As illustrated in FIG. 14A, the magnetism discrimination apparatus compares a detection waveform of a medium with normal waveform data which has been stored in advance to verify the authenticity of the medium. As illustrated in FIG. 14B, the magnetism discrimination apparatus determines the kind of the medium. Both examples may be used for judgment or discrimination of bill, etc.

Specifically, in the example of FIG. 14A, an output signal from the magnetic substance detection sensor 1 is taken into a CPU 39 as a digital signal through an A/D converter 37. In this instance, normal waveform data is stored in advance in the memory 38. A detection waveform and the normal waveform are compared with each other at a comparing unit 43 of the CPU 39 to thereby perform an authenticity verification.

In the example of FIG. 14B, normal waveform data are stored in advance every kind of media in the memory 38. An output signal from the magnetic substance detection sensor 1 is similarly taken into the CPU 39 as a digital signal through the A/D converter 37 to compare, at the comparing unit 43 of the CPU 39, detection waveform and waveform every medium of the memory 38 to thereby perform kind determination of the medium.

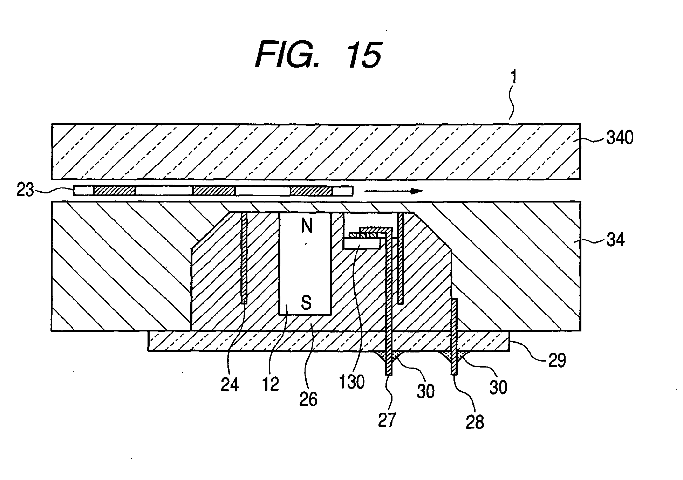

As the magnetic substance detection sensor 1 of FIGS. 14A and 14B, e.g., the configuration of FIG. 15 may be used. In FIG. 15, reference numerals are respectively attached to the same portions as those of FIGS. 8A and 8B. In FIG. 15, the medium 23 travels within a passage in the state where upper and lower portions are restricted. The magnetic substance detection sensor 1 is disposed within carrying path formation members 34 and 340 which form the above-mentioned passage.

Thus, there can be realized a high reliability magnetism discrimination apparatus in which a sensor does not take up space and a medium is not jammed. This configuration can be realized because the magnetic substance detection sensor of the present invention is compact, and a magnetoimpedance element having very high sensitivity, etc. can be used as compared to the prior art MR element.

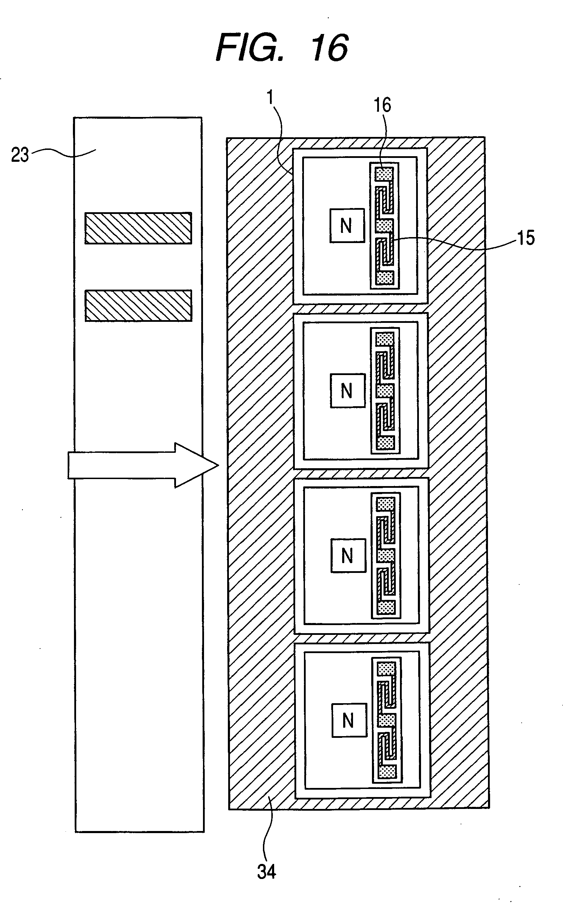

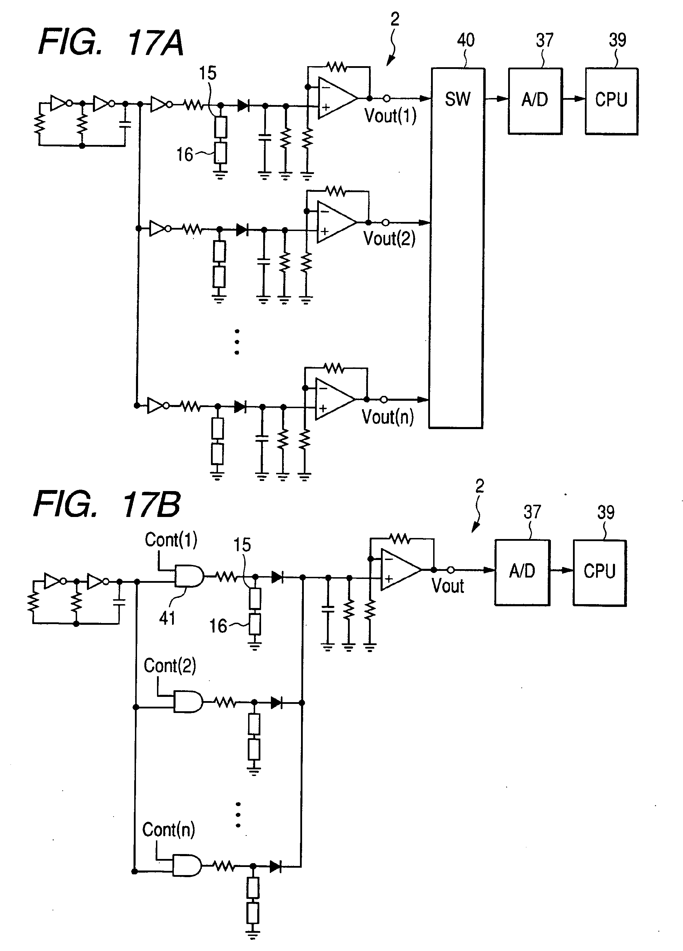

FIG. 16 and each of FIGS. 17A and 17B illustrate a two-dimensional distribution detecting apparatus as an example of the magnetic substance detecting apparatus using the magnetic substance detection sensor of the present invention. The parts designated at reference numerals 15, 16 in FIGS. 17A and 17B are magnetic films of the magnetic substance detection sensor 1. The part designated by reference numeral 2 is a magnetic substance detecting apparatus. FIG. 16 illustrates the configuration of the sensor unit, wherein the magnetic substance detection sensors 1 are arranged in line in a manner perpendicular to the traveling direction of the medium 23. Respective magnetic substance detection sensors have, e.g., the configuration similar to FIG. 15. Shields are arranged with respect to the respective magnetic substance detection sensors thus to prevent interference between the magnetic substance detection sensors.

FIGS. 17A and 17B each illustrate an apparatus configuration including driving circuits. In FIG. 17A, an oscillating circuit is commonly used, and driving circuits of FIG. 6C are arranged every magnetic substance detection sensor. Outputs thereof are sequentially read-in by switching of a switch 40, and are output to a CPU 39 through an A/D converter 37. The CPU 39 performs arithmetic processing by using a sensor signal. Thus, a two-dimensional magnetic distribution can be obtained.

In FIG. 17B, ON/OFF of each magnetic substance detection sensor is controlled by an AND circuit 41. By sequentially switching sensors each of which is turned ON, detection similar to FIG. 17A is performed. The circuit component designated at reference numeral 37 is an A/D converter similarly to FIG. 17A, and the circuit component designated at reference numeral 39 is a CPU.

In the magnetic substance detection sensor using the prior art high sensitivity magnetic field detection element, a very large scale circuit is required for driving operation of the sensor unit as illustrated in FIG. 16. On the other hand, the magnetic substance detection sensor of the present invention is used so that space can be reduced.

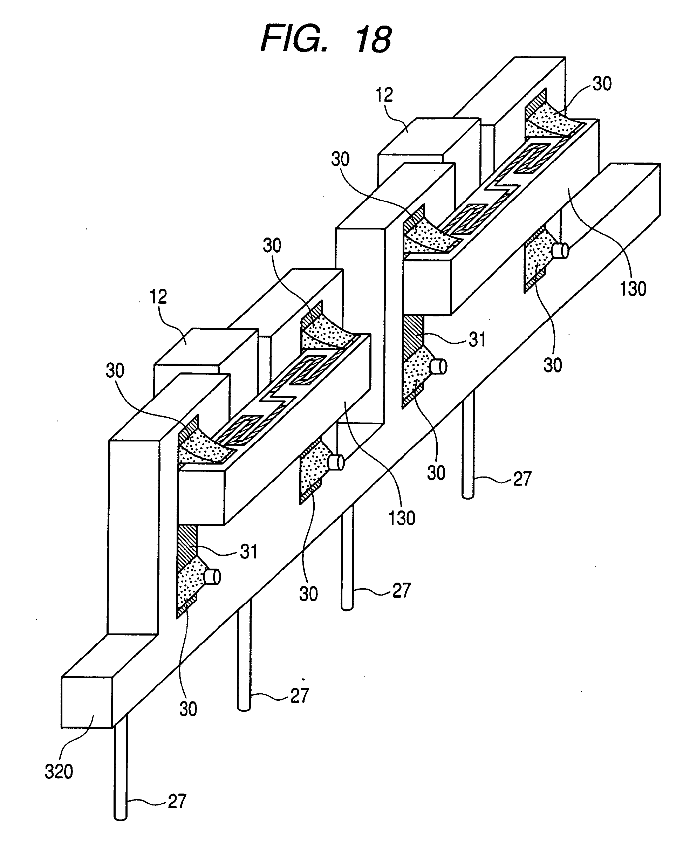

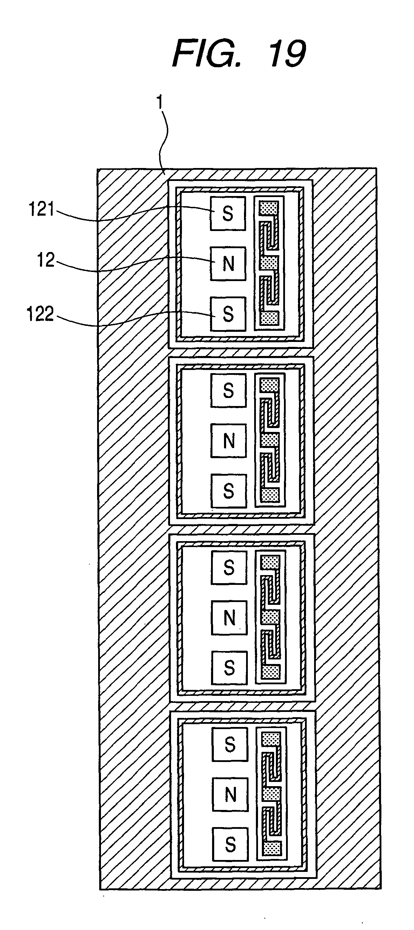

As mounting of the magnet and the magnetic field detection element, there may be employed a mounting form where plural magnetic field detection elements 130 and plural magnets 12 are disposed on the same printed circuit board 320 as illustrated in FIG. 18, for example. As the configuration of the sensor unit, the configuration of FIG. 19, etc. may be similarly employed in addition to FIG. 16. In FIGS. 18 and 19, the same reference numerals are respectively attached to the same portions of FIGS. 9A to 9D.

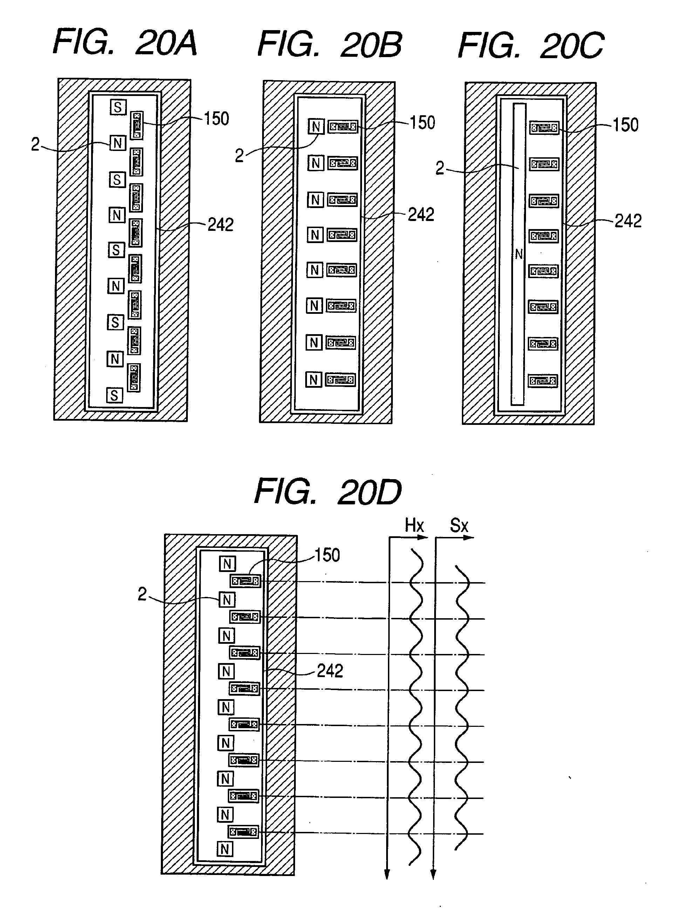

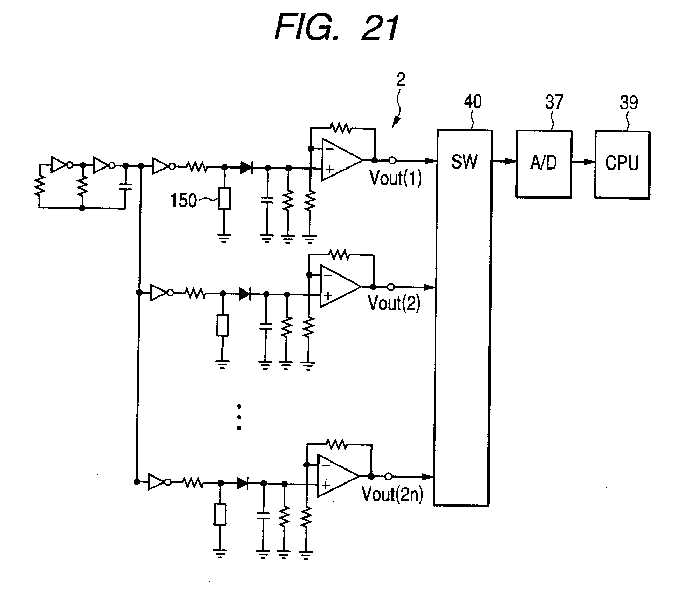

FIGS. 20A to 20D, and FIG. 21 illustrate another example of the two-dimensional magnetic distribution detecting apparatus as an example of a magnetic substance detecting apparatus using the magnetic substance detection sensor of the present invention. In FIG. 21, each magnetic field detection element 150 of the magnetic substance detection sensor 1 is illustrated. FIG. 20A illustrates the configuration in which the configurations of FIG. 5D are disposed in line, wherein magnets having polarities opposite to each other and magnetic field detection elements 150 are arranged at predetermined intervals, and two magnetic field detection elements adjacent to each other thereamong and a magnet therebetween constitute a single magnetic substance detection sensor.

Moreover, a magnetic shield 242 is disposed so as to surround the entirety of arrangement of the magnets 2 and the magnetic field detection elements 150 except for the plane opposite to a medium. FIG. 20B illustrates the configuration in which the configurations of FIG. 1A are disposed in line. The magnets 2 having the same polarity and the magnetic field detection elements 150 are disposed at predetermined intervals. FIG. 20C illustrates the configuration in which the magnets of FIG. 20B is replaced by an elongated magnet 2.

FIG. 20D illustrates the configuration in which the configurations of FIG. 5F are disposed in line. As indicated by the right graph of FIG. 20D, detection sensitivity Sx of the element and detection direction component Hx of a magnetic field applied to a medium alternately increase or decrease with respect to the line direction. For this reason, the region having low detection sensitivity is compensated by the magnitude of magnetization produced. Thus, detection having no unevenness can be made.

Here, by arranging the plural magnetic substance detection sensors of the present invention as illustrated in FIGS. 20A to 20D, a magnetic substance line sensor is constituted. Moreover, the magnetic substance detecting apparatus of the present invention performs detection of magnetic substance by using the magnetic substance detection sensor, or the magnetic substance line sensor of the present invention.

FIG. 21 illustrates an apparatus configuration including such driving circuits. An oscillation circuit is commonly used, and driving circuits are arranged every respective magnetic field detection elements. In FIG. 21, the same reference numerals are respectively attached to the same portions of FIG. 17A.

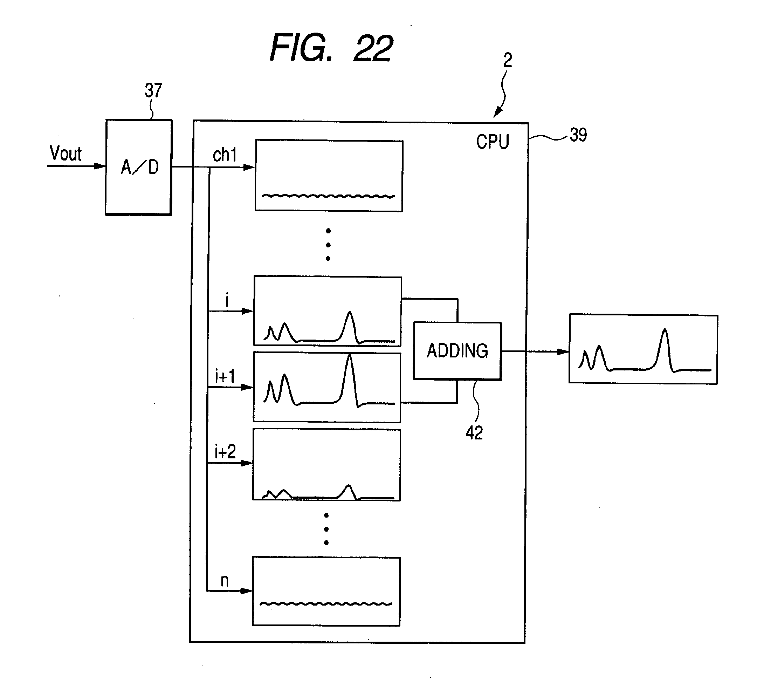

FIG. 22 illustrates an example of signal processing in the case where this configuration is used. This signal processing is applied to the configuration of the magnetic substance detection line sensor. By adding outputs from two (plural) magnetic field detection elements by an adding unit 42 as illustrated in FIG. 22, position and width of detection can be freely set while removing the influence of a noise magnetic field. In FIG. 22, processing similar to differential detection is performed by addition of two sensors (unit of multiple of 2 = even number unit) from arrangement of sensors.

In this configuration, although the driving circuit becomes large, complying with various media can be performed only by changing the signal processing part without exchanging the sensor unit. Thus, an extremely high performance magnetic distribution detecting apparatus can be realized.

(Second exemplary embodiment)

Another exemplary embodiment for carrying out the invention will now be described. A magnetic field detection element is disposed on a plane positioned on the side of a magnetic pole opposite to a magnetic pole to which a magnetic substance becomes close of a magnet from the middle point of the NS axis of the magnet with the NS direction of the magnet being as normal, and is such that a bias magnetic field applied from the magnet is disposed at a position which is set within the region where magnetization of the magnetic field detection element is saturated.

Moreover, the magnetic field detection element is disposed on the same plane as that of the magnetic pole of the side opposite to the magnetic pole to which the magnetic substance becomes close of the magnet. The magnet and the magnetic field detection element are mounted on the same board. Further, there exist at least two magnetic field detection elements, and they are disposed linear-symmetrically with respect to a single straight line on a plane intersecting with normal on the plane. A signal corresponding to sum of outputs of the two magnetic field detection elements is output.

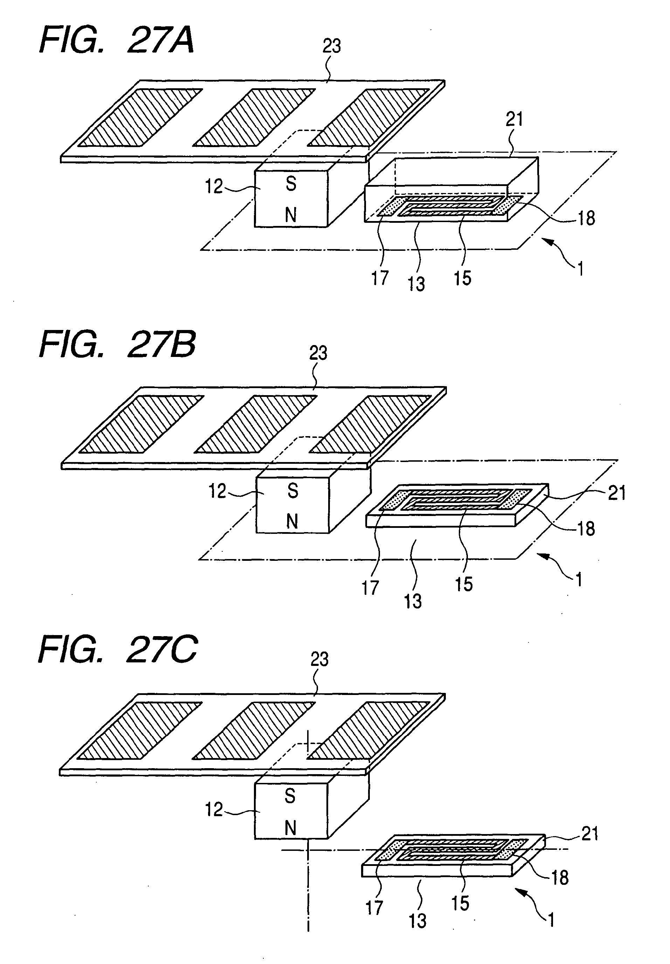

FIGS. 27A to 27C illustrate the fundamental configuration of the second exemplary embodiment. FIGS. 27A to 27C respectively illustrate the exemplary embodiments of the present invention, wherein arrangements of magnetic field detection elements 13 are different from each other. In FIG. 27A, a magnetic substance detection sensor 1 includes a magnet 12 and a magnetic field detection element 13, wherein the magnetic field detection element 13 is disposed on the same plane as that of the N-pole of the magnet 12.

The magnetic field detection element 13 includes a magnetic film 15 and electrodes 17, 18 which are formed on a non-magnetic substrate 21, wherein the length direction of the magnetic film 15 is in correspondence with the magnetic field detection direction. A medium 23 containing magnetic material becomes close to the S-pole of the magnet 12 to detect a magnetic field change in that instance by the magnetic field detection element 13.

In FIG. 27B, the magnetic field detection element 13 is adapted so that the rear surface of the non-magnetic substrate 21 is disposed on the same plane as that of the N-pole of the magnet 12. Other components are similar to those of FIG. 27A. While the magnetic detection element 13 may be located at a position further far from the medium 23 as illustrated in FIG. 27C, arrangement of FIG. 27A or 27B is desired from a viewpoint of easiness of mounting.

The configuration of FIG. 27A is a configuration suitable for soldering mounting, etc. FIG. 27B illustrates the configuration suitable for mounting by wire-bonding, etc. For the electrodes 17, 18, material such as Cu or A1, etc. may be selected in conformity with those electrodes. While there is a necessity in the configuration of FIG. 27B that the thickness of the non-magnetic substrate 21 is caused to be one half of the NS axis of the magnet 12 or less, the thickness equal to the NS axis can be ensured in FIG. 27A. In the case where the NS axis of the magnet 12 is shortened for the purpose of realizing thin structure of the magnetic substance detection sensor 1, the configuration of FIG. 27A is desired from a viewpoint of the strength of the substrate 21.

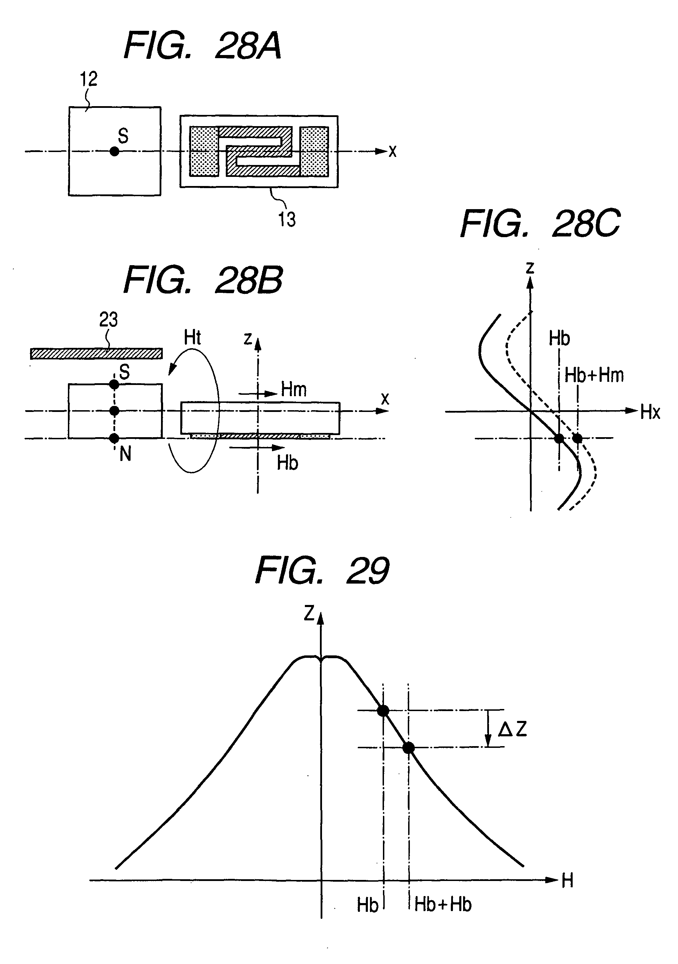

The principle of detection of the present invention will now be described with reference to FIGS. 28A to 28C and FIG. 29. While description will be made by taking, as an example, the configuration of FIG. 27A in the following description, the principle of detection is entirely the same also in the configuration of FIG. 27B. FIG. 28A is a diagram when the state of FIG. 27A is viewed from upper direction, and FIG. 28B is a diagram when the state of FIG. 27A is viewed from the side surface. In FIGS. 28A to 28C, the magnetic field detection element 13 is such that the x-direction perpendicular to the NS axis of the magnet 12 is in correspondence with magnetic field detection direction. In this case, the magnetic field detection element 13 undergoes a bias magnetic field Hb from the magnet 12.

The bias magnetic field Hb is greatly changed with respect to position in the z-direction in parallel to the NS axis of the magnet 12. In this case, if the magnet 12 and the magnetic field detection element 13 are mounted on, e.g., the same board, etc., positional accuracy can be easily obtained. Moreover, the magnetic field detection element 13 undergoes a large magnetic field Hz in the film thickness direction of the magnetic film from the magnet 12. However, since demagnetizing field is large, there is no large influence on the characteristic of the magnetic field detection element.

FIG. 28C illustrates a distribution of the bias magnetic field Hb depending upon position in the z-direction, which varies from the distribution of solid line to the distribution of dotted line in dependency upon presence or absence of the medium 23. The magnetic field changes in a direction where the bias magnetic field decreases on the side close to the medium 23 with respect to the center of the NS axis, and in a direction where the bias magnetic field increases on the side far from the medium 23 as in the case of the arrangement of FIG. 28.

FIG. 29 illustrates one example of the element characteristic. The magnetic field detection element has the characteristic expressed as even function with respect to the magnitude of a magnetic field such that the impedance value monotonously decreases. In the state where there is no medium 23, the bias point of the magnetic field detection element 13 is located at the position of Hb. By proximity of the medium 23, the bias point shifts to the point of (Hb + Hm). Impedance change ΔZ at this time takes a negative value.

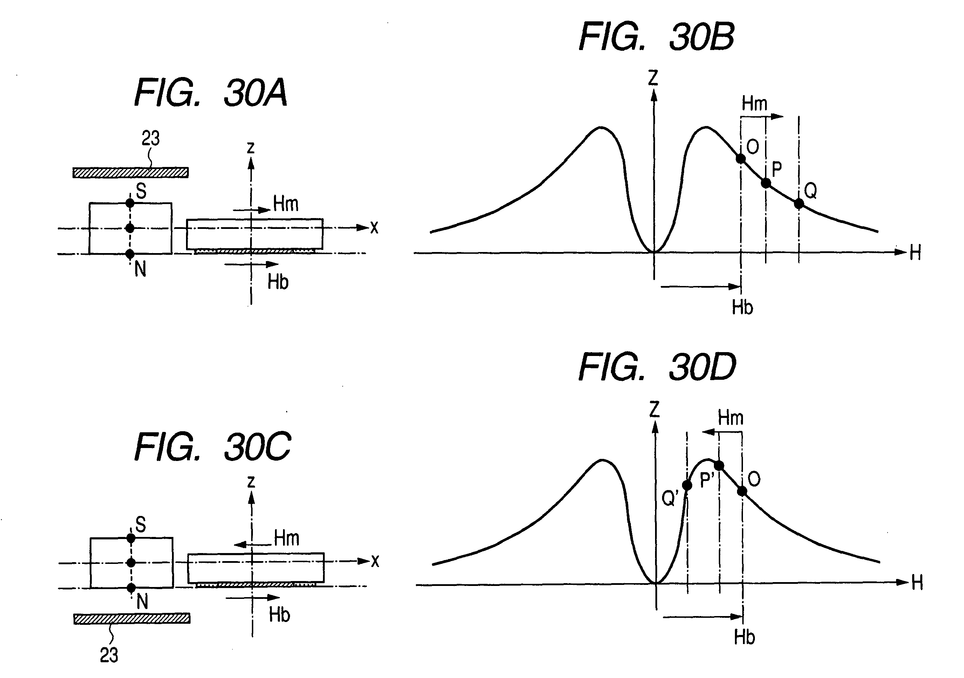

FIGS. 30A to 30D illustrate difference of impedance change of the magnetic field detection element by the proximity method of medium. FIGS. 30A and 30B illustrate change in the case where the medium 23 becomes close to the magnetic pole which is far relative to the magnetic field detection element 13, and FIGS. 30C and 30D illustrate change in the case where the medium 23 becomes close to the magnetic pole which is near relative thereto. In FIGS. 30A and 30B, magnetic field change Hm by the medium 23 takes place in a direction where the bias magnetic field Hb increases. Even if shift is performed from the point O of FIGS. 30A and 30B to the point P and the point Q, there is no problem in the characteristic of the magnetic field detection element.

On the other hand, in FIGS. 30C and 30D, magnetic field change Hm takes place in a direction in which the bias magnetic field Hb decreases. When the bias magnetic field change Hm shifts from the point O to the point P', Q', the impedance value changes from increase to decrease. As a result, change would not comply with magnetic quantity of the medium 23. While description has been made with reference to the characteristic of FIG. 4E in FIGS. 30A to 30D, the characteristic is unstable within a certain magnetic field range with the zero magnetic field being as the center also in the case of the characteristic of FIG. 4A. When the point of operation enters that region, there results a unsatisfactory operation. In the case of use purpose where magnetic quantity of the medium is large as stated above, the proximity method of FIGS. 30A and 30B is desired.

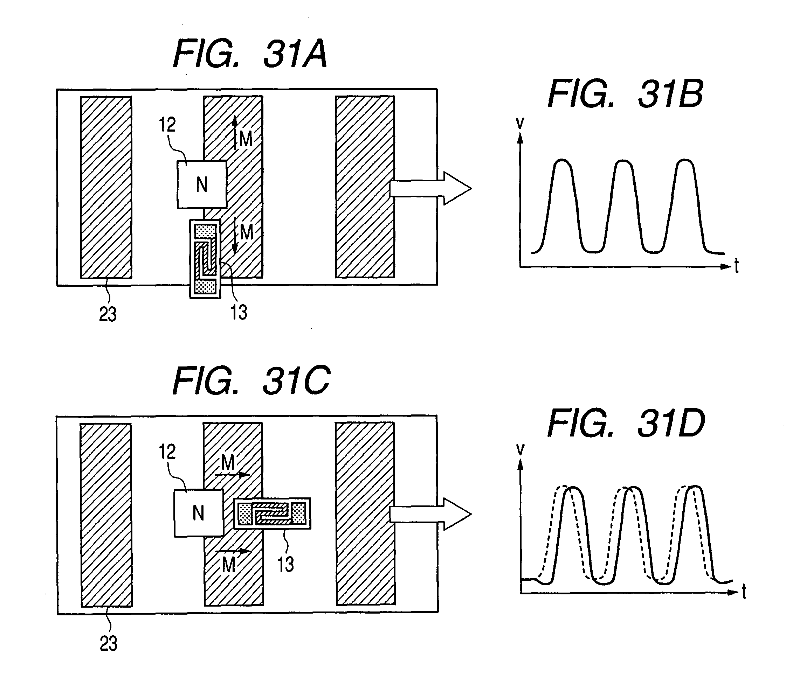

The method of detecting a medium according to the present invention will now be described. Detection of a medium may be performed in the state where the medium is stopped, or may be continuously performed while moving the medium relative to the sensor. FIGS. 31A to 31D illustrate an example of movement direction of medium and output signal in the case of continuously performing detection while moving the medium in parallel to the magnetic pole surface of the magnet. FIGS. 31A and 31B illustrate an output example in the case of moving a stripe-shaped medium in a direction perpendicular to the magnetic field detection direction of the magnetic field detection element.

In this movement direction, at a timing where the region having magnetism is passed through the part on the magnetic pole, a peak corresponding to magnetic quantity of the pattern is detected. On the contrary, an output in the case of moving that a region in parallel to the magnetic field detection direction is as illustrated in FIGS. 31C and 31D. As a result, timing shifts to some extent, and overshoots appear on both sides of the peak corresponding to a magnetic quantity. For this reasons, in the ordinary magnetic quantity detection, it is desirable to move the region in the direction perpendicular to the magnetic field detection direction as illustrated in FIGS. 31A and 31B.

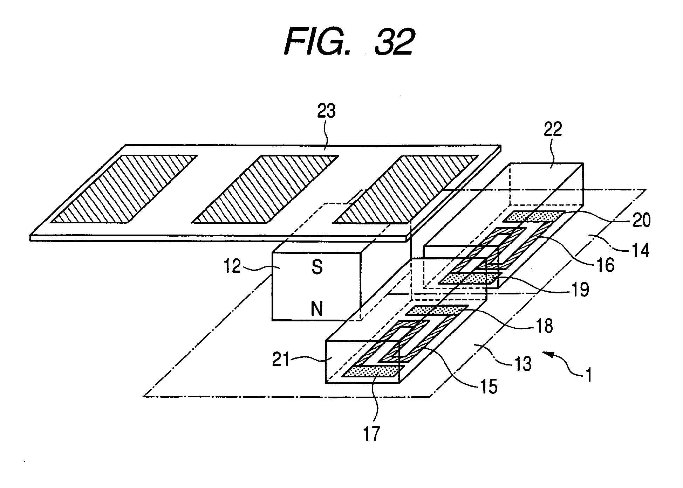

The configuration effective in detecting a very small magnetic quantity with good accuracy will now be described. FIG. 32 illustrates the configuration using a magnet 12 and two magnetic field detection elements 13, 14. Those components are arranged on the same plane similarly to FIG. 1. In FIG. 32, the same reference numerals are respectively attached to the same portions as those of FIG. 1. The magnetic field detection elements 13, 14 are arranged, with the magnetic field detection being aligned, in the state arranged in that direction.

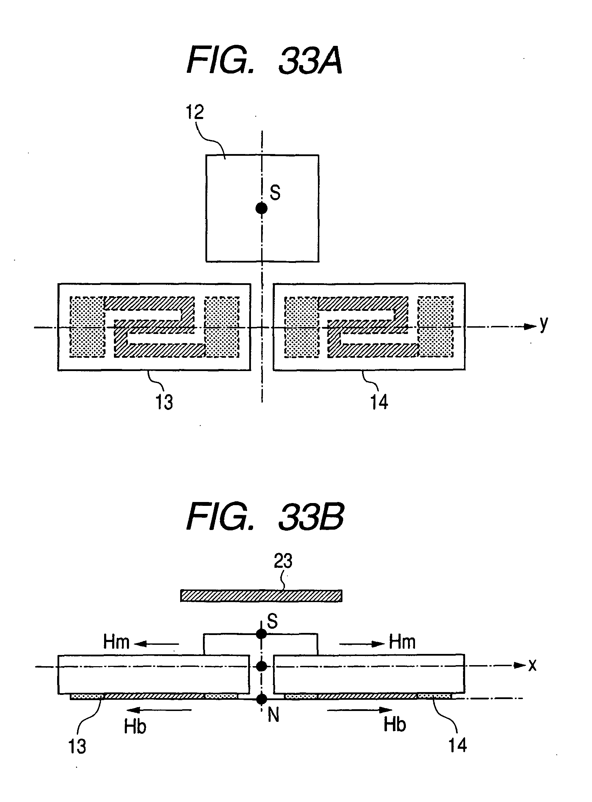

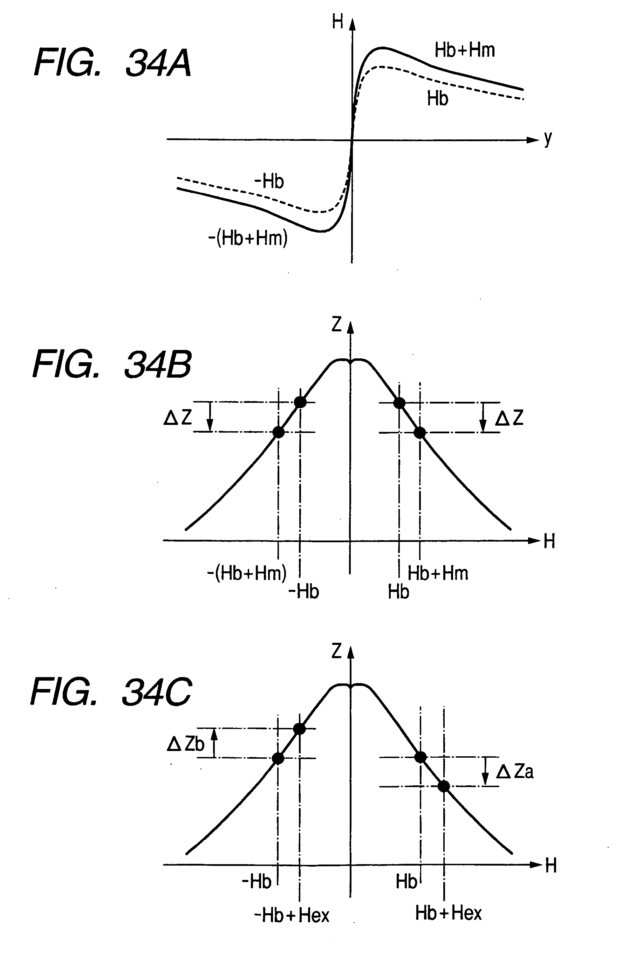

The principle of detection in this configuration will be described with reference to FIGS. 33A and 33B, and FIGS. 34A and 34C. FIG. 33A illustrates a diagram when the configuration of FIG. 32 is viewed from upper direction, and FIG. 33B is a diagram when the configuration of FIG. 32 is viewed front face. In FIGS. 33A and 33B, the magnetic field detection elements 13, 14 have the magnetic field detection direction in the y-direction, and undergoes a bias magnetic fields Hb in directions opposite to each other from the magnet 12. Similarly to the case of FIGS. 27A to 27C, the magnitude of a bias magnetic field can be suitably set by a distance between the NS of the magnet 12 as well as the position of the magnetic field detection element.

The medium 23 is magnetized symmetrically with respect to the NS axis of the magnet 12 so that the magnetic field detection elements 13, 14 undergo a magnetic fields Hm in directions opposite to each other. FIG. 34A illustrates a magnetic field distribution by position in the magnetic field detection direction, which changes from the distribution of the solid line to the distribution of dotted line in dependency upon presence or absence of the medium 23.

The magnetic field detection elements 13, 14 are disposed at a position where change is small except for the portion in the vicinity of the center of the magnetic field distribution. FIG. 34B illustrates an example of the element characteristic. Those elements have the characteristic expressed as even function with respect to the magnitude of a magnetic field such that the impedance value monotonously decreases. In the state where there is no medium 23, bias points of the magnetic field detection elements 13 and 14 are located at positions of -Hb and Hb. By proximity of the medium 23, the bias point shifts to the points of -(Hb + Hm) and (Hb + Hm).

The impedance changes ΔZ at this time are the same with respect to the magnetic field detection elements 13, 14. By taking a sum of those impedance changes, change of 2ΔZ can be obtained. FIG. 34C illustrates change in the case where an external magnetic field Hex is applied. The element characteristic and the bias point are similar to those of FIG. 34B. Bias points of the magnetic field detection elements 13 and 14 shift to -Hb + Hex and Hb + Hex. Thus, impedance changes ΔZb and ΔZa are produced.

If the external magnetic field is sufficiently small with respect to linearity of the element characteristic, ΔZb + ΔZa becomes equal to zero. By detecting sum of impedance values of the magnetic field detection elements 13, 14 in this way, the external magnetic field are cancelled. Thus, only change by the medium 23 can be detected.

A practical example of the second exemplary embodiment will now be described. While description will be made in the following description by taking an example of the fundamental configuration of FIG. 32 in which the case where high precision detection is performed is assumed, implementation may be similarly performed even in the case of the configurations of FIGS. 27A to 27C.

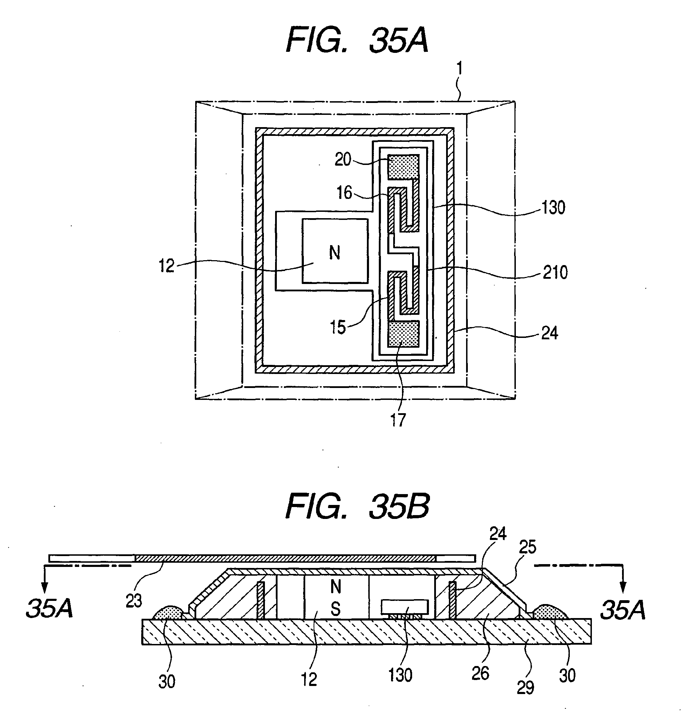

FIGS. 35A and 35B illustrate a magnetic substance detection sensor 1 according to the present example. In FIGS. 35A and 35B, the diagram in which the inside of the magnetic substance detection sensor 1 is viewed from upper direction and the diagram in which it is viewed from the side surface are respectively illustrated. A magnet 12 and a magnetic field detection element 130 are surface-mounted on a driving circuit board 29, and a shield 24, a holder 26 and a case 25 are arranged so as to surround those members. The spacing between the magnet 12 and the magnetic field detection element 130 is 0.5 mm, and the outer shape of the case 25 has dimensions of about 6 × 6 × 0.7 mm³. Thus, the thin structure can be realized.

As the magnet 12, there is used a neodymium magnet having magnetic pole area of 1 mm × 1 mm and height of 0.6 mm. The magnetic field detection element 130 is fabricated similarly to the first exemplary embodiment. Magnetic films 15, 16 are formed on a substrate 210. These films are connected in series. At both ends thereof, there are formed electrodes 17, 20. As the substrate 210, there is used a ceramic board of calcium titanate having thickness of 0.2 mm.

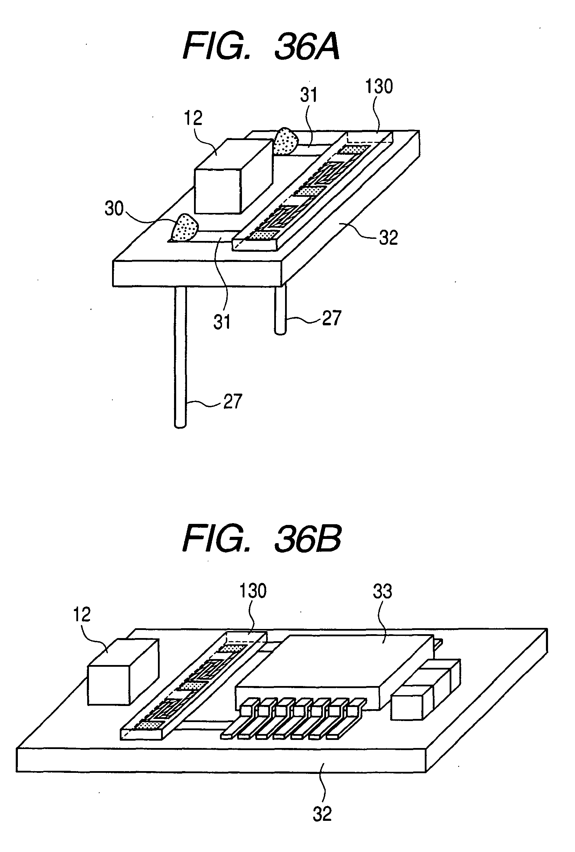

FIGS. 36A and 36B illustrate a mounting example of magnet 12 and magnetic field detection element 130. In the example of FIG. 36A, a magnet 12 and a magnetic field detection element 130 are mounted on a printed circuit board 32, and is connected to an external driving circuit by means of terminals 27.

In the example of FIG. 36B, a magnet 12, a magnetic filed detection element 130 and a driving circuit 33 are mounted on the same surface of a printed circuit board 32. In accordance with the present example, the space of the driving circuit can be reduced. A magnetic substance detection sensor convenient in use of the driving circuit integral type illustrated in FIG. 36B can be easily constituted. In FIGS. 36A and 36B, the part designated by reference numeral 30 is solder, and the part designated by reference numeral 31 is copper wiring.

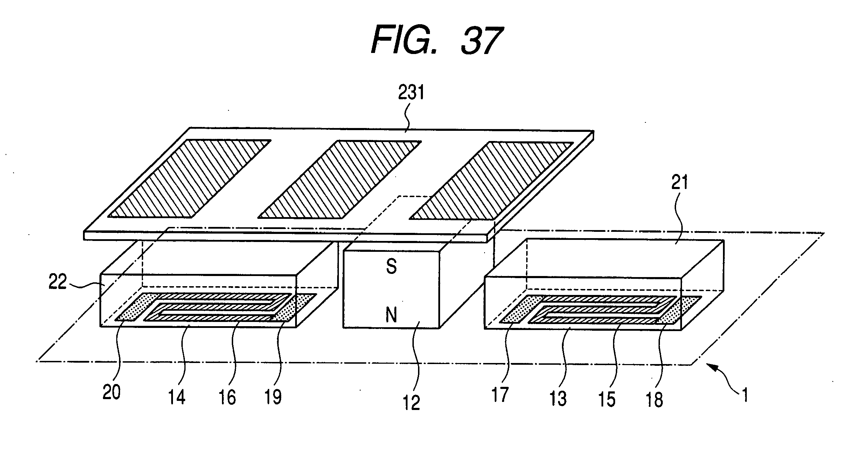

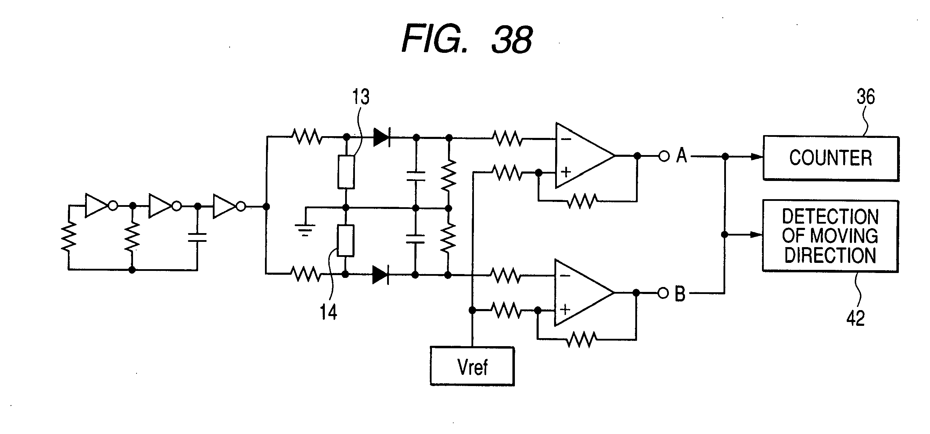

FIGS. 37 and 38 illustrate another example of an encoder as an example of the magnetic substance detecting apparatus using magnetic substance detection sensor of the present invention. In FIG. 38, magnetic filed detection elements 13, 14 of the magnetic substance detection sensor are illustrated. The part designated by reference numeral 2 is a magnetic substance detecting apparatus. As illustrated in FIG. 37, magnetic filed detection elements 13, 14 are arranged on both sides of a magnet 12 as illustrated in FIG. 37. A medium 231 is moved in a direction where two magnetic field detection elements are arranged. Outputs corresponding to impedance values of the magnetic field detection elements 13, 14 are respectively pulsated with reference voltage Vref being as reference at the apparatus of FIG. 38 so that outputs A and B are obtained. By counting outputs of A and B by a counter 36, an encoder output can be obtained.

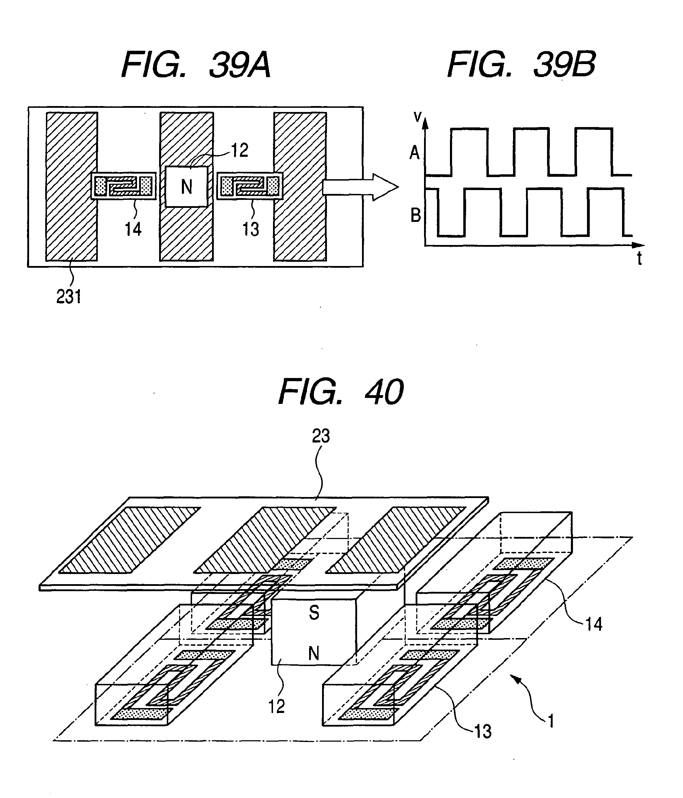

The configuration of FIG. 37 is such that the two configurations of FIGS 27A to 27C are arranged with the magnet 12 being shared. Timings of respective outputs are shifted in terms of time as illustrated in FIGS. 31C and 31D. For this reason, as illustrated in FIGS. 39A and 39B, output signals of A and B result in phase-shifted pulse with respect to movement of a medium. In view of the above, by detecting order of rising of two pulse outputs by a moving direction detecting circuit 37 as illustrated in FIG. 38, movement direction of the medium can be also detected.

In the case where magnetic quantity of a medium is small and the influence of a noise magnetic field such as earth magnetism, etc. is large, there may be also used the configuration in which the two configurations of FIG. 32 are arranged, with the magnet 12 being shared, on both sides thereof as illustrated in FIG. 40. As stated above, the magnetic substance detecting apparatus of the present invention may take a configuration in which two magnetic substance detection sensors are arranged with the magnet being shared.

In the case where magnetic quantity of a medium is very large, e.g., in the case of a medium obtained by processing a magnetic plate, etc., an attractive force is exerted when a magnetic substance passes on the magnetic pole so that resistance force is produced in movement. If this magnetic substance is freely moved or is rotatably held, the magnetic substance is stopped on the magnetic pole. By detecting the number of magnetic substances and the movement direction thereof which have passed on the magnetic pole by making use of the above phenomenon, an input device generating feeling of steering by resistance force can be constituted. Such input device can be suitably used as a rotary selector (jog dial) used in, e.g., mobile telephone or AV equipment, etc.

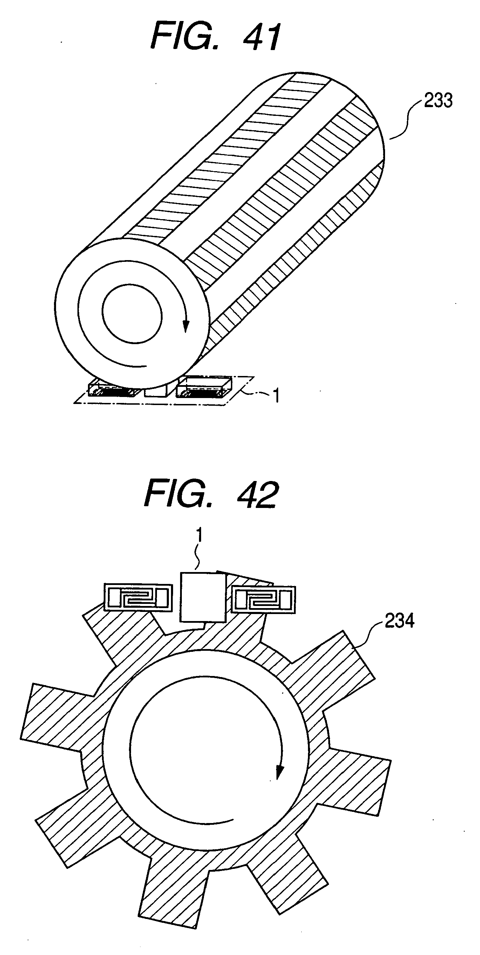

FIGS. 41 and 42 illustrate an example of the configuration thereof. In the case of FIG. 41, by rotating a tubular medium 233, the above configuration functions as an input device. In the case of FIG. 42, by rotating a disc-shaped medium 234, the above configuration functions as input device. When the magnetic substance detection sensor of the present invention is used, a very thin and low cost input device having lesser number of parts can be constituted.

The configuration of the input device of the present invention includes a magnetic substance detecting apparatus in which two magnetic substance detection sensors are arranged with a magnet being shared, and a movable member (tubular medium 233 or disc-shaped medium 234) in which magnetic substances are disposed at preset intervals. Moreover, the input device is configured so as to include a circuit for pulsating respective outputs of two magnetic substance detection sensors by a threshold valve determined in advance, and a circuit for detecting the movement quantity of a movable member and the movement direction thereof by phase difference between two pulse signals and the number of pulses thereof which are output in accordance with the movement of the movable member.

(Third exemplary embodiment)

A further exemplary embodiment for carrying out the invention will now be described in detail with reference to the attached drawings.

One of two magnetic field detection element is arranged on the N-pole side from the middle point of the NS axis of a magnet, and the other magnetic field detection element is disposed on the S-pole side from the middle point of the NS axis of the magnet. The two magnetic field detection elements are disposed so that their magnetic field detection directions are caused to be in parallel to a plane in which the NS direction of the magnet is caused to be normal.

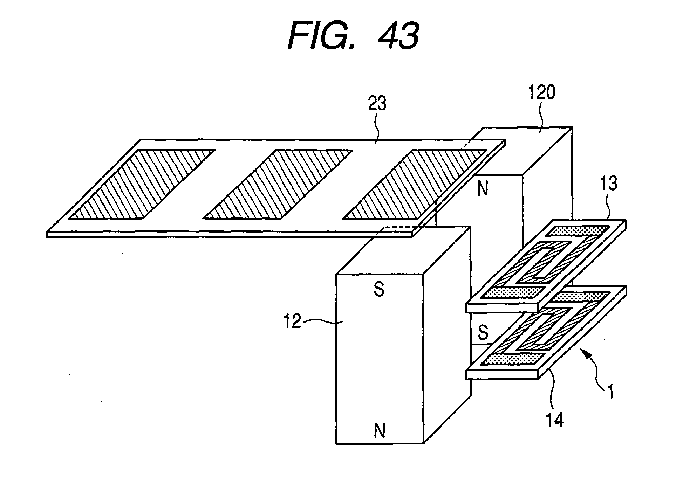

FIG. 43 illustrates the third exemplary embodiment of the present invention. This configuration is such that two magnets 12, 120 disposed with the polarity being opposite to each other are used to dispose magnetic field detection elements 13, 14 at upper and lower parts thereof. The magnetic field detection element 13 is disposed on the magnetic pole side in which a medium 23 becomes close from the center of the magnets 12 and 120, and the magnetic field detection element 14 is disposed on the magnetic pole side opposite thereto.

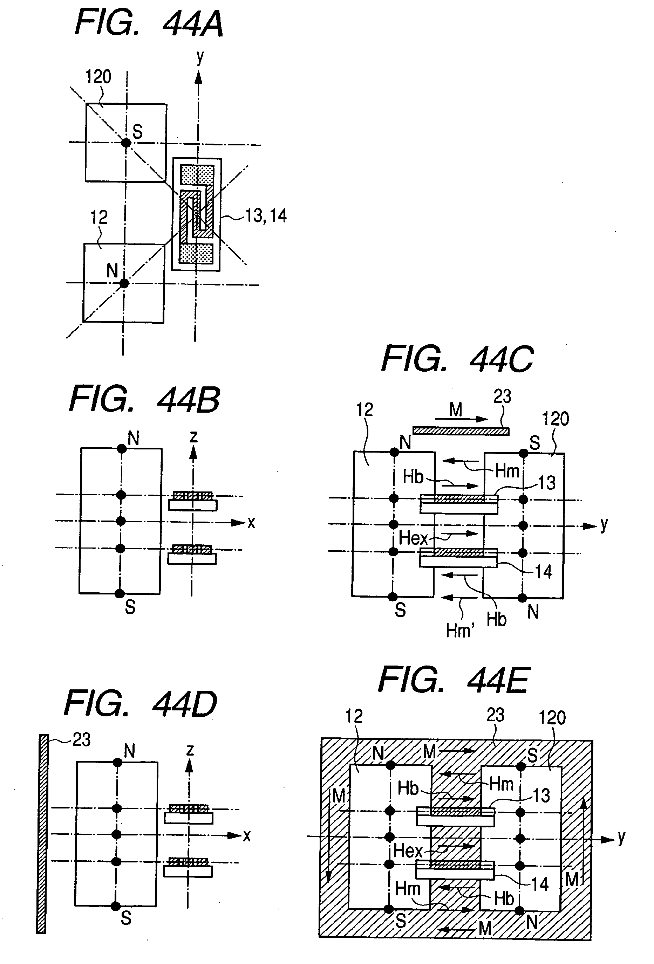

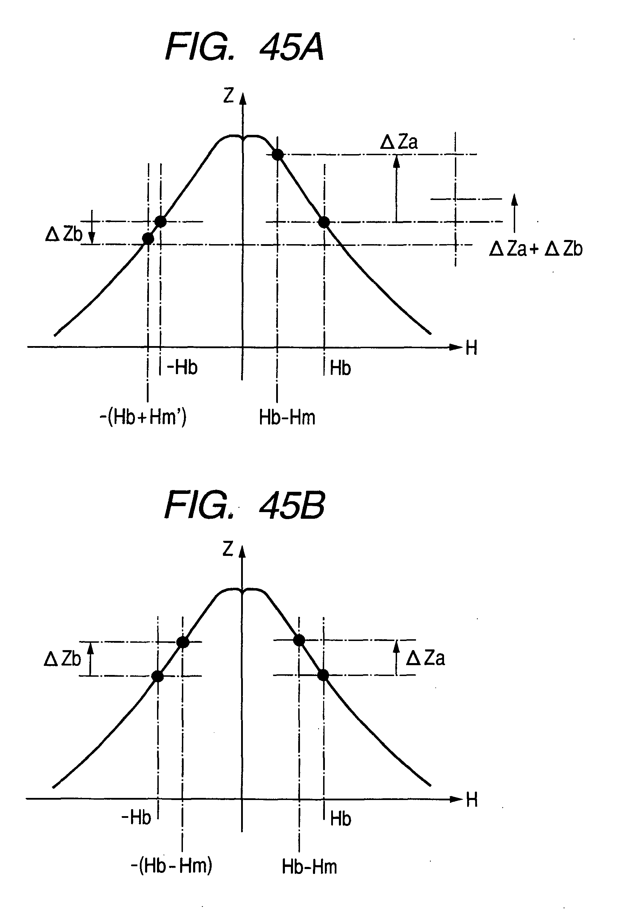

The operation of this configuration will be described with reference to FIGS. 44A to 44E, and FIGS. 45A and 45B. FIG. 44A is a diagram in which the configuration of FIG. 43 is viewed from the upper direction, FIG. 44B is a diagram in which the configuration of FIG. 43 is viewed from the side surface, and FIG. 44C is a diagram in which the configuration of FIG. 43 is viewed from the front face. As shown in FIG. 44C, the magnetic field detection elements 13, 14 undergo a bias magnetic fields Hb in directions opposite to each other from the magnets 12 and 120. The medium 23 is magnetized from the N-pole of the magnet 12 toward the S-pole of the magnet 120. As a result, the magnetic field detection elements 13, 14 respectively undergo magnetic fields Hm, Hm' in the same direction.

Here, Hm > Hm' holds by a difference between distances from the medium 23. The operation at this time is as illustrated in FIG. 45A. The points of operation of the magnetic field detection elements 13 and 14 shift from Hb and -Hb to (Hb - Hm) and - (Hb + Hm') to produce impedance changes ΔZa and ΔZb.

Because |ΔZa| > |ΔZb| , sum of impedance values of two magnetic field detection elements also changes so that ΔZa + ΔZb > 0. For an external magnetic field, similarly to FIG. 3C, ΔZa + ΔZb becomes equal to zero. In the case where the medium 23 is caused to become close to magnets 12 and 120 in parallel to the NS axis, magnetization takes place in the directions in parallel to and perpendicular to the NS axis of the magnet as shown in FIG. 44E. Thus, the magnetic field detection elements 13, 14 undergo the magnetic fields Hm in directions opposite to each other.

The operation at this time is as shown in FIG. 45B. This operation is similar to that of FIG. 3B. Also in the configuration of FIG. 43, sum of impedance values of the magnetic field detection elements 13, 14 is detected to thereby cancel an external magnetic field. Thus, only change by the medium 23 can be detected.

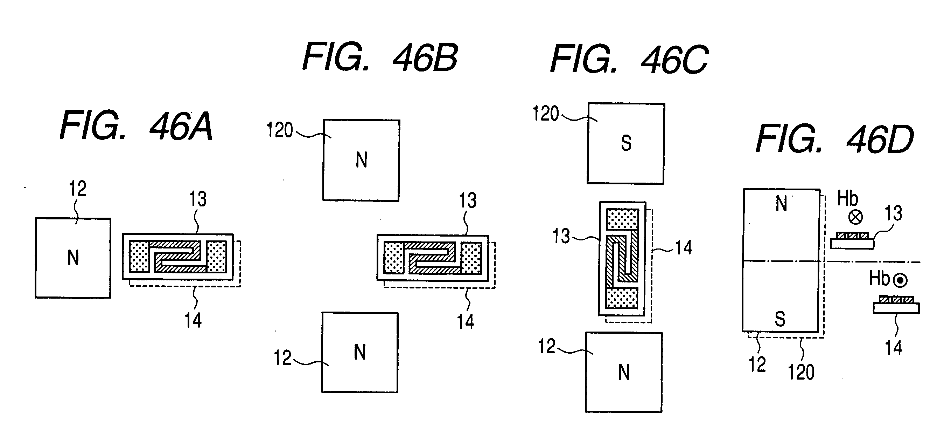

FIGS. 46A to 46D each illustrate an arrangement example of magnet and magnetic field detection element. In addition to the arrangement of FIG. 43, there may be employed a configuration including a single magnet as illustrated in FIG. 46A. As illustrated in FIG. 46B, the magnetic field detection element may be disposed between two magnets of the same polarity. Moreover, as illustrated in FIG. 46C, two magnetic field detection elements may be disposed between magnets. Further, if bias magnetic fields have directions opposite to each other, and have the same magnitude, there may be employed, as illustrated in FIG. 46D, an arrangement in which magnetic field detection elements 13, 14 are asymmetrical with respect to the center of the NS axis of a magnet.

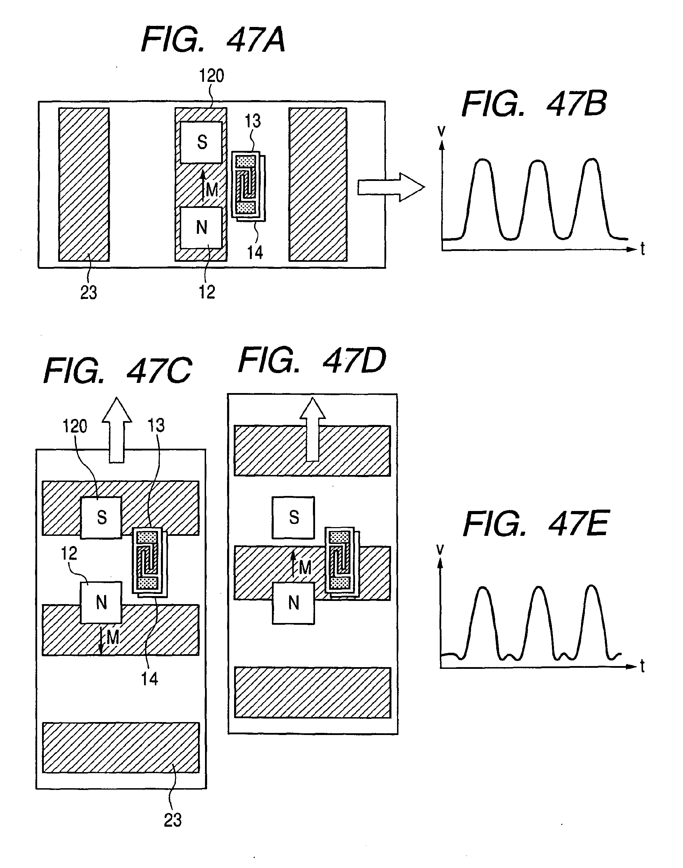

FIGS. 47A to 47E illustrate an example of movement direction of medium and output signal in the case where the configuration of FIG. 43 is used. An output in the case of moving the medium in the direction perpendicular to the magnetic field detection direction of the magnetic field detection element as illustrated in FIGS. 47A and 47B is the same as in FIGS. 7A and 7B. In the case of moving the medium in parallel to the magnetic field detection direction as illustrated in FIGS. 47C to 47E, there are instances where undershoot, etc. may take place in an output. Also in the configuration of FIG. 43, the configuration of FIGS. 47A and 47B is relatively desired.

A practical example of the third exemplary embodiment will now be described.

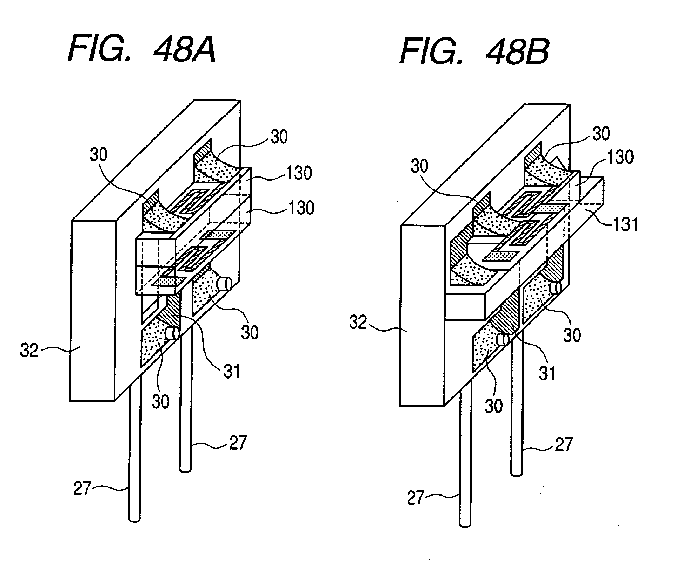

FIGS. 48A and 48B each illustrate an example of a mounting method of a magnet 12 and a magnetic field detection element 130.

In the example of FIG. 48A, there is employed an arrangement in which backsides of magnetic field detection elements are caused to be in correspondence with each other.

This mounting method may be also used for magnetic field detection elements formed, as film, on both surfaces. The example of FIG. 48B is a mounting method in the case where magnetic field detection elements 130, 131 are respectively disposed at upper and lower portions. An arrangement is made such that the surface of the other magnetic field detection element is caused to be in correspondence with the backside of one magnetic field detection element. In FIGS. 48A and 48B, the part designated by reference numeral 27 is a terminal, and the part designated by reference numeral 31 is copper wiring.

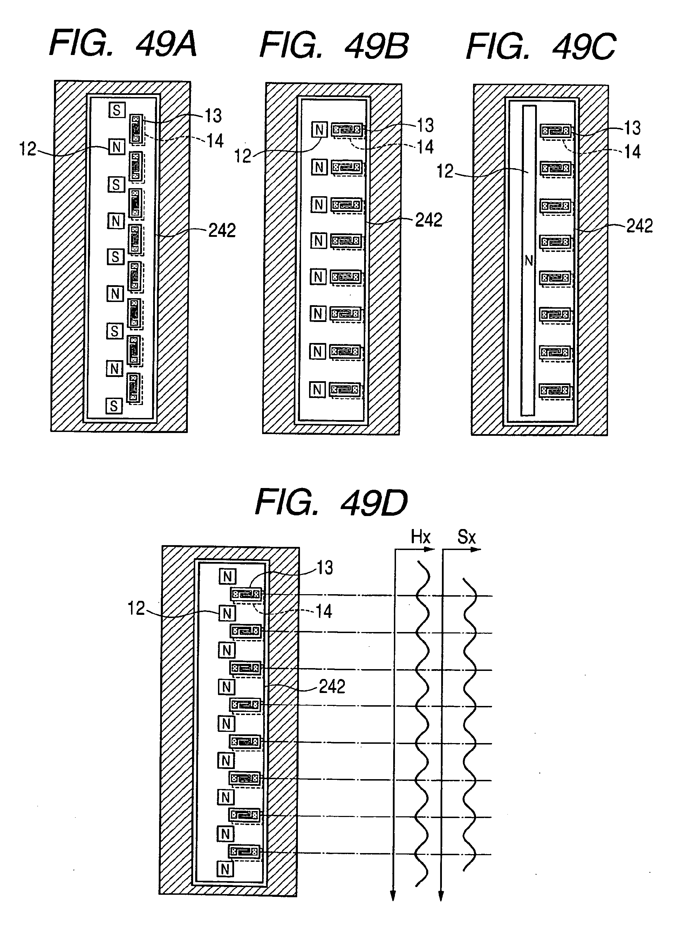

FIG. 49A illustrates the configuration in which the configurations of FIG. 43 are disposed in line. Two magnetic field detection elements are disposed in upper and lower directions along the NS direction of the magnet to constitute a single sensor. This configuration has a resolution in the line direction higher than that of FIG. 20A. Moreover, since a noise magnetic filed can be cancelled by upper and lower elements, this configuration is more tolerable to noises as compared to that of FIG. 20A.

FIG. 49B illustrates a configuration in which the configurations of FIG. 46A are disposed in line. Magnets having the same polarity and magnetic field detection elements are disposed at predetermined intervals. FIG. 49C illustrates the configuration in which the magnet of FIG. 49B is replaced by elongated magnet.

FIG. 49D illustrates a configuration in which the configurations of FIG. 46B are disposed in line. As indicated by the right graph of FIG. 49D, detection sensitivity Sx of elements and detection direction component Hx of a magnetic field applied to a medium increase or decrease alternately with respect to line direction. For this reason, a region having low detection sensitivity is compensated by the magnitude of magnetization produced so that detection free from unevenness can be made.

While the present invention has been described with reference to exemplary embodiments, it is to be understood that the invention is not limited to the disclosed exemplary embodiments. The scope of the following claims is to be accorded the broadest interpretation so as to encompass all such modifications and equivalent structures and functions.
The present invention aims at providing a magnetic substance detection sensor: which permits a high sensitivity magnetic field detection element to be effectively operative even in the vicinity of a magnet; which permits quantitative detection without depending upon the magnetic characteristic of a medium, e.g., soft magnetic material, etc.; which is compact and permits realization of reduced space; and which has high productivity. In addition, the present invention aims at providing a compact and high performance magnetic substance detecting apparatus. Specifically, in a magnetic substance detection sensor including a magnet producing a magnetic field, and a magnetic field detection element for detecting change of the magnetic field, the magnetic field detection element is disposed on a plane intersecting with the NS axis of the magnet at a point except for the middle point thereof with the NS direction of the magnet being as normal so that the magnetic field detection direction becomes in parallel to the plane, and a bias magnetic field is formed by the magnet.

## Claims

1. A magnetic substance detection sensor comprising:
a magnetic field detection element,
a bias magnet (**12**) producing a bias magnetic field
for the magnetic field detection element (**13, 14**) detecting change of the magnetic field,
**characterized in that**
the magnetic field detection element **(13, 14)** is disposed on a side of the bias magnet and on a plane intersecting with an NS axis of the bias magnet at a point except a middle point between the N-pole and the S-pole thereof so that a normal line of the plane points to a direction of the NS axis and a magnetic field detection direction is in parallel to the plane.

2. The magnetic substance detection sensor according to claim 1,
wherein the magnetic field detection element has a magnetic thin film **(15, 16),** and the magnetic field detection direction is in parallel to a film surface of the magnetic thin film.

3. The magnetic substance detection sensor according to claim 1,
wherein the magnetic field detection element **(13, 14)** is disposed so that the magnetic field detection direction is inclined from a radial direction of the NS axis of the bias magnet **(12).**

4. The magnetic substance detection sensor according to claim 1,
wherein the bias magnetic field is disposed at a position which is set within a region where magnetization of the magnetic field detection element **(13, 14)** is saturated.

5. The magnetic substance detection sensor according to claim 4,
wherein the magnetic field detection element **(13, 14)** is disposed close to a magnetic pole of the side opposite to a magnetic pole in which a magnetic substance detected becomes close to the bias magnet **(12).**

6. The magnetic substance detection sensor according to claim 1,
wherein the bias magnet **(12)** and the magnetic field detection element **(13, 14)** are mounted on the same board.

7. The magnetic substance detection sensor according to claim 1,
wherein the magnetic field detection element **(13, 14)** is a magnetoimpedance element.

8. The magnetic substance detection sensor according to claim 1,
wherein two magnetic field detection elements are disposed linearly symmetrical with respect to a single straight line on the plane intersecting with the normal on the plane intersecting with an NS axis of the bias magnet.

9. The magnetic substance detection sensor according to claim 8,
further comprising a circuit **(33)** for outputting a signal corresponding to the sum of outputs of the two magnetic field detection elements **(13, 14);**
wherein the two magnetic field detection elements are adapted so that bias magnetic fields in directions opposite to each other are applied to those elements from the bias magnet.

10. The magnetic substance detection sensor according to claim 9,
wherein the two magnetic field detection elements **(13, 14)** are connected in series.

11. The magnetic substance detection sensor according to claim 9,
wherein one of the two magnetic field detection elements is disposed on the N-pole side from the middle point of an NS axis of the magnet, and the other magnetic field detection element is disposed on the S-pole side from the middle point of the NS axis of the magnet, a magnetic field detection direction of each of the two magnetic field detection elements being caused to be in parallel to a plane in which an NS direction of the magnet is caused to be normal.

12. The magnetic substance detection sensor according to claim 9,
wherein the bias magnetic field is disposed at a position which is set within a region where magnetization of the magnetic field detection element is saturated.

13. A magnetic substance detecting apparatus comprising:
a member for carrying a medium with the magnetic substance; and
a plurality of the magnetic substance detection sensors according to the claim 1.

14. A magnetic substance detecting apparatus according to claim 13, wherein at least two magnetic substance detection sensors share the bias magnet **(12).**

15. An input device comprising:
two magnetic substance detecting apparatus according to claim 13;
a movable member **(233; 234)** in which magnetic substances are disposed at predetermined intervals;
a circuit for pulsating respective outputs of the two magnetic substance detection sensors based on a predetermined threshold value; and
a circuit **(36, 37)** for detecting a movement quantity and a movement direction of the movable member based on a phase difference between the two pulse signals which are output in accordance with the movement of the movable member, and the number of pulses thereof.

## Patentansprüche

1. Erfassungssensor für magnetische Substanzen, mit :
einem Magnetfelderfassungselement,
einem Vormagnetisierungsmagneten (12), der ein Vormagnetisierungsfeld für das Magnetfelderfassungselement (13, 14) erzeugt, das eine Änderung des magnetischen Feldes erfasst,
**dadurch gekennzeichnet, dass**
das Magnetfelderfassungselement (13, 14) an einer Seite des Vormagnetisierungsmagneten und auf einer Ebene angeordnet ist, die sich mit einer NS-Achse des Vormagnetisierungsmagneten an einem Punkt mit Ausnahme eines Mittelpunktes zwischen dem N-Pol und dem S-Pol davon schneidet, so dass eine Normale der Ebene in eine Richtung der NS-Achse zeigt und eine Magnetfelderfassungsrichtung parallel zu der Ebene ist.

2. Erfassungssensor für magnetische Substanzen nach Anspruch 1,
wobei das Magnetfelderfassungselement eine dünne magnetische Schicht (15, 16) aufweist, und die Magnetfelderfassungsrichtung parallel zu einer Schichtoberfläche der dünnen magnetischen Schicht ist.

3. Erfassungssensor für magnetische Substanzen nach Anspruch 1,
wobei das Magnetfelderfassungselement (13, 14) derart angeordnet ist, dass die Magnetfelderfassungsrichtung von einer radialen Richtung der NS-Achse des Vormagnetisierungsmagneten (12) weg geneigt ist.

4. Erfassungssensor für magnetische Substanzen nach Anspruch 1,
wobei das Vormagnetisierungsfeld an einer Position angeordnet ist, die innerhalb eines Bereichs festgelegt ist, in dem eine Magnetisierung des Magnetfelderfassungselements (13, 14) gesättigt ist.

5. Erfassungssensor für magnetische Substanzen nach Anspruch 4,
wobei das Magnetfelderfassungselement (13, 14) nah bei einem Magnetpol an der Seite angeordnet ist, die gegenüber einem Magnetpol liegt, an dem eine erfasste magnetische Substanz dem Vormagnetisierungsmagneten (12) nah kommt.

6. Erfassungssensor für magnetische Substanzen nach Anspruch 1,
wobei der Vormagnetisierungsmagnet (12) und das Magnetfelderfassungselement (13, 14) auf derselben Platine angebracht sind.

7. Erfassungssensor für magnetische Substanzen nach Anspruch 1,
wobei das Magnetfelderfassungselement (13, 14) ein Magnetoimpedanzelement ist.

8. Erfassungssensor für magnetische Substanzen nach Anspruch 1,
wobei zwei Magnetfelderfassungselemente linearsymmetrisch bezüglich einer einzelnen geraden Linie auf der Ebene angeordnet sind, die sich mit der Normalen auf der Ebene schneidet, die sich mit einer NS-Achse des Vormagnetisierungsmagneten schneidet.

9. Erfassungssensor für magnetische Substanzen nach Anspruch 8,
ferner mit einem Schaltkreis (33) zur Ausgabe eines Signals entsprechend der Summe von Ausgaben der zwei Magnetfelderfassungselemente (13, 14);
wobei die zwei Magnetfelderfassungselemente derart eingerichtet sind, dass Vormagnetisierungsfelder in zueinander entgegen gesetzten Richtungen von dem Vormagnetisierungsmagneten an diese Elemente angelegt sind.

10. Erfassungssensor für magnetische Substanzen nach Anspruch 9,
wobei die zwei Magnetfelderfassungselemente (13, 14) in Reihe verbunden sind.

11. Erfassungssensor für magnetische Substanzen nach Anspruch 9,
wobei eines der zwei Magnetfelderfassungselemente auf der N-Pol-Seite von dem Mittelpunkt einer NS-Achse des Magneten aus angeordnet ist, und das andere Magnetfelderfassungselement auf der S-Pol-Seite von dem Mittelpunkt der NS-Achse des Magneten aus angeordnet ist, wobei eine Magnetfelderfassungsrichtung jedes der zwei Magnetfelderfassungselemente dazu gebracht ist, parallel zu einer Ebene zu sein, in der eine NS-Richtung des Magneten dazu gebracht ist, eine Normale zu sein.

12. Erfassungssensor für magnetische Substanzen nach Anspruch 9,
wobei das Vormagnetisierungsfeld an einer Position angeordnet ist, die innerhalb eines Bereichs festgelegt ist, in dem eine Magnetisierung des Magnetfelderfassungselements gesättigt ist.

13. Erfassungsvorrichtung für magnetische Substanzen, mit:
einem Bauelement zum Tragen eines Mediums mit der magnetischen Substanz; und
einer Vielzahl von Erfassungssensoren für magnetische Substanzen nach Anspruch 1.

14. Erfassungsvorrichtung für magnetische Substanzen nach Anspruch 13, wobei sich zumindest zwei Erfassungssensoren für magnetische Substanzen den Vormagnetisierungsmagneten (12) teilen.

15. Eingabegerät, mit:
zwei Erfassungsvorrichtungen für magnetische Substanzen nach Anspruch 13;
einem beweglichen Bauelement (233, 234), in dem magnetische Substanzen in vorbestimmten Intervallen angeordnet sind;
einem Schaltkreis zur Pulsierung entsprechender Ausgaben der zwei Erfassungssensoren für magnetische Substanzen basierend auf einem vorbestimmten Schwellenwert; und
einem Schaltkreis (36, 37) zur Erfassung einer Bewegungsmenge und einer Bewegungsrichtung des beweglichen Bauelements basierend auf einer Phasendifferenz zwischen den zwei Pulssignalen, die gemäß der Bewegung des beweglichen Bauelements ausgegeben werden, und der Anzahl an Pulsen davon.

## Revendications

1. Capteur de détection de substances magnétiques comprenant :
un élément de détection de champ magnétique,
un aimant de polarisation (12) produisant un champ magnétique de polarisation pour l'élément de détection de champ magnétique (13, 14) détectant une modification du champ magnétique,
**caractérisé en ce que**
l'élément de détection de champ magnétique (13, 14) est disposé d'un côté de l'élément de polarisation et sur un plan coupant un axe NS de l'aimant de polarisation en un point différent d'un point milieu entre son pôle N et son pôle S afin qu'une ligne perpendiculaire au plan pointe dans une direction de l'axe NS et qu'une direction de détection du champ magnétique soit parallèle au plan.

2. Capteur de détection de substances magnétiques selon la revendication 1,
dans lequel l'élément de détection de champ magnétique comporte un film mince magnétique (15, 16), et la direction de détection du champ magnétique est parallèle à une surface de film du film mince magnétique.

3. Capteur de détection de substances magnétiques selon la revendication 1,
dans lequel l'élément de détection de champ magnétique (13, 14) est disposé de façon que la direction de détection du champ magnétique soit inclinée par rapport à une direction radiale de l'axe NS de l'aimant de polarisation (12).

4. Capteur de détection de substances magnétiques selon la revendication 1,
dans lequel le champ magnétique de polarisation est disposé à une position qui est fixée à l'intérieur d'une région dans laquelle la magnétisation de l'élément de détection de champ magnétique (13, 14) est saturée.

5. Capteur de détection de substances magnétiques selon la revendication 4,
dans lequel l'élément de détection de champ magnétique (13, 14) est disposé à proximité d'un pôle magnétique du côté opposé au pôle magnétique dans lequel une substance magnétique détectée se rapproche de l'aimant de polarisation (12).

6. Capteur de détection de substances magnétiques selon la revendication 1,
dans lequel l'aimant de polarisation (12) et l'élément de détection de champ magnétique (13, 14) sont montés sur la même carte.

7. Capteur de détection de substances magnétiques selon la revendication 1,
dans lequel l'élément de détection de champ magnétique (13, 14) est un élément de magnéto-impédance.

8. Capteur de détection de substances magnétiques selon la revendication 1,
dans lequel les éléments de détection de champ magnétique sont disposés de manière linéairement symétrique par rapport à une droite unique contenue dans le plan coupant la perpendiculaire au plan passant par un axe NS de l'aimant de polarisation.

9. Capteur de détection de substances magnétiques selon la revendication 8,
comprenant en outre un circuit (33) destiné à délivrer un signal correspondant à la somme de sorties des deux éléments de détection de champ magnétique (13, 14) ;
dans lequel les deux éléments de détection de champ magnétique sont adaptés de façon que des champs magnétiques de polarisation soient appliqués à ces éléments dans des directions opposées l'un à l'autre par l'aimant de polarisation.

10. Capteur de détection de substances magnétiques selon la revendication 9,
dans lequel les deux éléments de détection de champ magnétique (13, 14) sont connectés en série.

11. Capteur de détection de substances magnétiques selon la revendication 9,
dans lequel l'un des deux éléments de détection de champ magnétique est disposé du côté du pôle N par rapport au point milieu d'un axe NS de l'aimant, et l'autre élément de détection de champ magnétique est disposé du côté du pôle S par rapport au point milieu de l'axe NS de l'aimant, une direction de détection de champ magnétique de chacun des deux éléments de détection de champ magnétique étant amenée à être parallèle à un plan par rapport auquel la direction NS de l'aimant est amenée à être perpendiculaire.

12. Capteur de détection de substances magnétiques selon la revendication 9,
dans lequel le champ magnétique de polarisation est disposé à une position qui est fixée à l'intérieur d'une région dans laquelle la magnétisation de l'élément de détection de champ magnétique est saturée.

13. Appareil de détection de substances magnétiques comprenant :
un élément destiné à porter un milieu contenant la substance magnétique ; et
une pluralité des capteurs de détection de substances magnétiques selon la revendication 1.

14. Appareil de détection de substances magnétiques selon la revendication 13, dans lequel au moins deux capteurs de détection de substances magnétiques partagent l'aimant de polarisation (12).

15. Dispositif d'entrée comprenant :
deux appareils de détection de substances magnétiques selon la revendication 13 ;
un élément mobile (233 ; 234) dans lequel des substances magnétiques sont disposées à des intervalles prédéterminés;
un circuit destiné à mettre sous la forme d'impulsions des sorties respectives des deux capteurs de détection de substances magnétiques par rapport à une valeur seuil prédéterminée ; et
un circuit (36, 37) destiné à détecter une distance de mouvement et une direction de mouvement de l'élément mobile sur la base d'une différence de phase entre les deux signaux impulsionnels qui sont délivrés en fonction du mouvement de l'élément mobile, et du nombre d'impulsions de ce dernier.
